(19) Europäisches Patentamt
European Patent Office
Office européen des brevets

(11) EP 3 160 972 B1

(12) **EUROPEAN PATENT SPECIFICATION**

(45) Date of publication and mention of the grant of the patent:
**24.07.2019 Bulletin 2019/30**

(21) Application number: **15725502.7**

(22) Date of filing: **03.06.2015**

(51) Int Cl.:
***C07F 7/08*** (2006.01) ***C07F 7/30*** (2006.01)
***H01L 51/00*** (2006.01)

(86) International application number:
**PCT/EP2015/001127**

(87) International publication number:
**WO 2016/000804 (07.01.2016 Gazette 2016/01)**

(54) **EXTENDED NON-LINEAR ACENE DERIVATIVES AND THEIR USE AS ORGANIC SEMICONDUCTORS**

ERWEITERTE NICHTLINEARE ACENDERIVATE UND DEREN VERWENDUNG ALS ORGANISCHE HALBLEITER

DÉRIVÉS D'ACÈNE NON LINÉAIRES ÉTENDUS ET LEUR UTILISATION COMME SEMI-CONDUCTEURS ORGANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2014 EP 14002239**

(43) Date of publication of application:
**03.05.2017 Bulletin 2017/18**

(73) Proprietor: **Merck Patent GmbH**
**64293 Darmstadt (DE)**

(72) Inventors:
- **MITCHELL, William**
**Chandler's**
**Ford SO53 3PE (GB)**
- **D'LAVARI, Mansoor**
**Stratton**
**Bude EX23 9AG (GB)**
- **WANG, Changsheng**
**Eastleigh SO53 3GW (GB)**
- **SPARROWE, David**
**Bournemouth BH6 3AB (GB)**

(56) References cited:
**WO-A1-2012/076092**

- **DAN LEHNHERR ET AL: "Synthesis and Properties of Isomerically Pure Anthrabisbenzothiophenes", ORGANIC LETTERS, vol. 14, no. 1, 6 January 2012 (2012-01-06), pages 62-65, XP055205009, ISSN: 1523-7060, DOI: 10.1021/ol202843x**
- **COMBE CRAIG M S ET AL: "Synthesis and morphology of asymmetric, alkyne-functionalised pentacene and 2-fluoroanthradithiophene", TETRAHEDRON LETTERS, vol. 54, no. 50, 11 October 2013 (2013-10-11), pages 6814-6818, XP028765836, ISSN: 0040-4039, DOI: 10.1016/J.TETLET.2013.10.006**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 160 972 B1

## Description

### Field of the Invention

The invention relates to extended non-linear acene derivatives, methods of their preparation, their use as semiconductors in organic electronic (OE) devices, and OE devices comprising them.

### Background and Prior Art

In recent years, there has been development of organic semiconducting (OSC) materials in order to produce more versatile, lower cost electronic devices. Such materials find application in a wide range of devices or apparatus, including organic field effect transistors (OFETs), organic light emitting diodes (OLEDs), photodetectors, organic photovoltaic (OPV) cells, sensors, memory elements and logic circuits to name just a few. The organic semiconducting materials are typically present in the electronic device in the form of a thin layer, for example less than 1 micron thick.

The performance of OFET devices is principally based upon the charge carrier mobility of the semiconducting material and the current on/off ratio, so the ideal semiconductor should have a low conductivity in the off state, combined with a high charge carrier mobility (> 1 x $10^{-3}$ $cm^2/Vs$). In addition, it is important that the semiconducting material is relatively stable to oxidation i.e. it has a high ionisation potential, as oxidation leads to reduced device performance. Further requirements for the semiconducting material are a good processability, especially for large-scale production of thin layers and desired patterns, and high stability, film uniformity and integrity of the organic semiconductor layer.

In prior art various materials have been proposed for use as OSCs in OFETs, including small molecules like for example pentacene, and polymers like for example polyhexylthiophene.

A promising class of conjugated small molecule semiconductors has been based upon the pentacene unit (see J. E. Anthony, Angew. Chem. Int. Ed., 2008, 47, 452). When deposited as a thin film by vacuum deposition, it was shown to have carrier mobilities in excess of 1 $cm^2/Vs$ with very high current on/off ratios greater than $10^6$ (see S. F. Nelson, Y. Y. Lin, D. J. Gundlach and T. N. Jackson, Appl. Phys. Lett., 1998, 72, 1854). However, vacuum deposition is an expensive processing technique that is unsuitable for the fabrication of large-area films. Initial device fabrication was improved by adding solubilising groups, such as trialkylsilylethynyl, allowing mobilities >0.1 $cm^2/Vs$ (see Maliakal, K. Raghavachari, H. Katz, E. Chandross and T. Siegrist, Chem. Mater., 2004, 16, 4980). It has also been reported that adding further substituents to the pentacene core unit can improve its semiconducting performance in field-effect transistor (FET) devices.

However, the OSC materials of prior art, and devices comprising them, which have been investigated so far, do still have several drawbacks, and their properties, especially the solubility, processibility, charge-carrier mobility, on/off ratio and stability still leave room for further improvement.

Therefore, there is still a need for OSC materials that show good electronic properties, especially high charge carrier mobility, and good processibilty, especially a high solubility in organic solvents. Moreover, for use in OFETs there is a need for OSC materials that allow improved charge injection into the semiconducting layer from the source-drain electrodes.

It was an aim of the present invention to provide compounds for use as organic semiconducting materials that do not have the drawbacks of prior art materials as described above, and do especially show good processibility, good solubility in organic solvents and high charge carrier mobility. Another aim of the invention was to extend the pool of organic semiconducting materials available to the expert.

It was found that these aims can be achieved by providing compounds as disclosed and claimed hereinafter. The inventors of the present invention have found that these compounds exhibit very good solubility in most organic solvents, especially those that are typically used in organic electronic device manufacture, show good thermal stability and high charge carrier mobility, and show high performance when used as semiconducting layer in electronic devices like OFETs.

WO 2012/076092 A1 discloses a class of conjugated small molecule based upon a non-linear acene unit, however, compounds as claimed hereinafter which contain an extended polycyclic unit with a sequence of more than five fused rings are not disclosed therein.

Dan Lehnherr et al., Organic Letters 2012, 14(1), 62-65 discloses organic semiconducting compounds with a polycyclic core, but does not disclose compounds as claimed in the present invention

### Summary of the Invention

The invention relates to compounds of formula 11 as defined in claim 1, wherein

A denotes C, Si or Ge,

R', R", R"' independently of each other denote H, straight-chain, branched or cyclic alkyl or alkoxy having 1 to 20 C atoms, straight-chain, branched or cyclic alkenyl having 2 to 20 C atoms, straight-chain, branched or cyclic group having 2 to 20 C atoms, straight-chain, branched or cyclic alkylcarbonyl having 2 to 20 C atoms, aryl or heteroaryl having 4 to 20 ring atoms, arylalkyl or heteroarylalkyl having 4 to 20 ring atoms, aryloxy or heteroaryloxy having 4 to 20 ring atoms, or arylalkyloxy or heteroarylalkyloxy having 4 to 20 ring atoms, wherein all the aforementioned groups are optionally substituted with one or more groups $R^S$,

$R^S$ denotes, on each occurrence identically or differently, F, Br, Cl, -CN, -NC, -NCO, -NCS, -OCN, -SCN, $-C(O)NR^0R^{00}$,$-C(O)X^0$, $-C(O)R^0$, $-C(O)OR^0$, $-NH_2$, $-NR^0R^{00}$, -SH, $-SR^0$,$-SO_3H$, $-SO_2R^0$, -OH, $-NO_2$, $-CF_3$, $-SF_5$, optionally substituted silyl, carbyl or hydrocarbyl with 1 to 40 C atoms that is optionally substituted and optionally comprises one or more hetero atoms,

$X^0$ denotes halogen, preferably F, Cl or Br,

$R^0$ and $R^{00}$ independently of each other denote H or alkyl with 1 to 20 C-atoms,

$Y^0$ and $Y^{00}$ independently of each other denote H, F, Cl or CN.

The invention further relates to a composition comprising one or more compounds of formula I1 and one or more binders, preferably selected from organic binders, very preferably from polymeric organic binders.

The invention further relates to an organic semiconducting composition comprising one or more compounds of formula I1, and one or more organic binders, preferably polymeric organic binders, or precursors thereof, preferably having a permittivity ε at 1,000 Hz and 20°C of 3.3 or less.

The invention further relates to a formulation comprising one or more compounds of formula I1 or a composition comprising it, and further comprising one or more solvents, preferably selected from organic solvents.

The invention further relates to the use of compounds and compositions according to the present invention as charge transport, semiconducting, electrically conducting, photoconducting or light emitting material in an optical, electrooptical, electronic, electroluminescent or photoluminescent device or a component thereof.

The invention further relates to the use of a compound of formula I1 or a composition comprising it as described above and below, as semiconducting, charge transport, electrically conducting, photoconducting, photoactive or light emitting material, or as a dye or pigment, preferably in an optical, electrooptical, electronic, electroluminescent or photoluminescent device, or in a component of such a device or in an assembly comprising such a device or component.

The invention further relates to a semiconducting, charge transport, electrically conducting, photoconducting, photoactive or light emitting material or a dye or pigment, comprising a compound of formula I1 or a composition comprising it.

The invention further relates to an optical, electrooptical, electronic, photoactive, electroluminescent or photoluminescent device, or a component thereof, or an assembly comprising it, which is prepared using a formulation as described above and below.

The invention further relates to an optical, electrooptical, electronic, photoactive, electroluminescent or photoluminescent device, or a component thereof, or an assembly comprising it, which comprises a compound of formula I1 or a composition comprising it.

The invention further relates to an optical, electrooptical, electronic, photoactive, electroluminescent or photoluminescent device, or a component thereof, which comprises a semiconducting, charge transport, electrically conducting, photoconducting or light emitting material or a dye or pigment according to the present invention as described above and below.

The optical, electrooptical, electronic, electroluminescent and photoluminescent devices include, without limitation, organic field effect transistors (OFET), organic thin film transistors (OTFT), organic light emitting diodes (OLED), organic light emitting transistors (OLET), organic photovoltaic devices (OPV), organic photodetectors (OPD), organic solar cells, dye-sensitized solar cells (DSSC), laser diodes, Schottky diodes, photoconductors, photodetectors and thermoelectric devices.

Preferred devices are OFETs, OTFTs, OPVs, OPDs and OLEDs, in particular bulk heterojunction (BHJ) OPVs or inverted BHJ OPVs.

Further preferred is the use of a compound of formula I1, or a composition comprising it, as dye in a DSSC or a perovskite-based solar cells, and a DSSC or perovskite-based solar cells comprising a compound of formula I1 or a composition comprising it.

The components of the above devices include, without limitation, charge injection layers, charge transport layers, interlayers, planarising layers, antistatic films, polymer electrolyte membranes (PEM), conducting substrates and conducting patterns.

The assemblies comprising such devices or components include, without limitation, integrated circuits (IC), radio frequency identification (RFID) tags or security markings or security devices containing them, flat panel displays or backlights thereof, electrophotographic devices, electrophotographic recording devices, organic memory devices, sensor devices, biosensors and biochips.

In addition the compound of formula I1 or a composition comprising it can be used as electrode materials in batteries and in components or devices for detecting and discriminating DNA sequences.

Terms and Definitions

As used herein, the term "polymer" will be understood to mean a molecule of high relative molecular mass, the structure of which essentially comprises the multiple repetition of units derived, actually or conceptually, from molecules of low relative molecular mass *(*Pure Appl. Chem., 1996, 68, 2291). The term "oligomer" will be understood to mean a molecule of intermediate relative molecular mass, the structure of which essentially comprises a small plurality of units derived, actually or conceptually, from molecules of lower relative molecular mass *(*Pure Appl. Chem., 1996, 68, 2291). In a preferred meaning as used herein present invention a polymer will be understood to mean a compound having > 1, i.e. at least 2 repeat units, preferably ≥ 5 repeat units, and an oligomer will be understood to mean a compound with > 1 and < 10, preferably < 5, repeat units. Further, as used herein, the term "polymer" will be understood to mean a molecule that encompasses a backbone (also referred to as "main chain") of one or more distinct types of repeat units (the smallest constitutional unit of the molecule) and is inclusive of the commonly known terms "oligomer", "copolymer", "homopolymer" and the like. Further, it will be understood that the term polymer is inclusive of, in addition to the polymer itself, residues from initiators, catalysts and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

As used herein, in a formula showing a polymer or a repeat unit, an asterisk (*) will be understood to mean a chemical linkage to an adjacent unit or to a terminal group in the polymer backbone. In a ring, like for example a benzene or thiophene ring, an asterisk (*) will be understood to mean a C atom that is fused to an adjacent ring.

As used herein, the terms "repeat unit", "repeating unit" and "monomeric unit" are used interchangeably and will be understood to mean the constitutional repeating unit (CRU), which is the smallest constitutional unit the repetition of which constitutes a regular macromolecule, a regular oligomer molecule, a regular block or a regular chain (Pure Appl. Chem., 1996, 68, 2291). As further used herein, the term "unit" will be understood to mean a structural unit which can be a repeating unit on its own, or can together with other units form a constitutional repeating unit.

As used herein, a "terminal group" will be understood to mean a group that terminates a polymer backbone. The expression "in terminal position in the backbone" will be understood to mean a divalent unit or repeat unit that is linked at one side to such a terminal group and at the other side to another repeat unit. Such terminal groups include endcap groups, or reactive groups that are attached to a monomer forming the polymer backbone which did not participate in the polymerisation reaction, like for example a group having the meaning of $R^5$ or $R^6$ as defined below.

As used herein, the term "endcap group" will be understood to mean a group that is attached to, or replacing, a terminal group of the polymer backbone. The endcap group can be introduced into the polymer by an endcapping process. Endcapping can be carried out for example by reacting the terminal groups of the polymer backbone with a monofunctional compound ("endcapper") like for example an alkyl- or arylhalide, an alkyl- or arylstannane or an alkyl- or arylboronate. The endcapper can be added for example after the polymerisation reaction. Alternatively the endcapper can be added in situ to the reaction mixture before or during the polymerisation reaction. In situ addition of an endcapper can also be used to terminate the polymerisation reaction and thus control the molecular weight of the forming polymer. Typical endcap groups are for example H, phenyl and lower alkyl.

As used herein, the term "small molecule" will be understood to mean a monomeric compound which typically does not contain a reactive group by which it can be reacted to form a polymer, and which is designated to be used in monomeric form. In contrast thereto, the term "monomer" unless stated otherwise will be understood to mean a monomeric compound that carries one or more reactive functional groups by which it can be reacted to form a polymer.

As used herein, the terms "donor" or "donating" and "acceptor" or "accepting" will be understood to mean an electron donor or electron acceptor, respectively. "Electron donor" will be understood to mean a chemical entity that donates electrons to another compound or another group of atoms of a compound. "Electron acceptor" will be understood to mean a chemical entity that accepts electrons transferred to it from another compound or another group of atoms of a compound. See also International Union of Pure and Applied Chemistry, Compendium of Chemical Technology, Gold Book, Version 2.3.2, 19. August 2012, pages 477 and 480.

As used herein, the term "n-type" or "n-type semiconductor" will be understood to mean an extrinsic semiconductor in which the conduction electron density is in excess of the mobile hole density, and the term "p-type" or "p-type

semiconductor" will be understood to mean an extrinsic semiconductor in which mobile hole density is in excess of the conduction electron density (see also, J. Thewlis, Concise Dictionary of Physics, Pergamon Press, Oxford, 1973).

As used herein, the term "leaving group" will be understood to mean an atom or group (which may be charged or uncharged) that becomes detached from an atom in what is considered to be the residual or main part of the molecule taking part in a specified reaction (see also Pure Appl. Chem., 1994, 66, 1134).

As used herein, the term "conjugated" will be understood to mean a compound (for example a polymer) that contains mainly C atoms with $sp^2$-hybridisation (or optionally also sp-hybridisation), and wherein these C atoms may also be replaced by hetero atoms. In the simplest case this is for example a compound with alternating C-C single and double (or triple) bonds, but is also inclusive of compounds with aromatic units like for example 1,4-phenylene. The term "mainly" in this connection will be understood to mean that a compound with naturally (spontaneously) occurring defects, or with defects included by design, which may lead to interruption of the conjugation, is still regarded as a conjugated compound.

As used herein, unless stated otherwise the molecular weight is given as the number average molecular weight $M_n$ or weight average molecular weight Mw, which is determined by gel permeation chromatography (GPC) against polystyrene standards in eluent solvents such as tetrahydrofuran, trichloromethane (TCM, chloroform), chlorobenzene or 1,2,4-trichlorobenzene. Unless stated otherwise, 1,2,4-trichlorobenzene is used as solvent. The degree of polymerization, also referred to as total number of repeat units, n, will be understood to mean the number average degree of polymerization given as $n = M_n/M_U$, wherein $M_n$ is the number average molecular weight and Mu is the molecular weight of the single repeat unit, see J. M. G. Cowie, Polymers: Chemistry & Physics of Modern Materials, Blackie, Glasgow, 1991.

As used herein, the term "carbyl group" will be understood to mean any monovalent or multivalent organic moiety which comprises at least one carbon atom either without any non-carbon atoms (like for example -C≡C-), or optionally combined with at least one non-carbon atom such as B, N, O, S, P, Si, Se, As, Te or Ge (for example carbonyl etc.).

As used herein, the term "hydrocarbyl group" will be understood to mean a carbyl group that does additionally contain one or more H atoms and optionally contains one or more hetero atoms like for example B, N, O, S, P, Si, Se, As, Te or Ge.

As used herein, the term "hetero atom" will be understood to mean an atom in an organic compound that is not a H- or C-atom, and preferably will be understood to mean B, N, O, S, P, Si, Se, As, Te or Ge.

A carbyl or hydrocarbyl group comprising a chain of 3 or more C atoms may be straight-chain, branched and/or cyclic, and may include spiro-connected and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 30, very preferably 1 to 24 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups do optionally contain one or more hetero atoms, preferably selected from B, N, O, S, P, Si, Se, As, Te and Ge.

Further preferred carbyl and hydrocarbyl group include for example: a $C_1$-$C_{40}$ alkyl group, a $C_1$-$C_{40}$ fluoroalkyl group, a $C_1$-$C_{40}$ alkoxy or oxaalkyl group, a $C_2$-$C_{40}$ alkenyl group, a $C_2$-$C_{40}$ alkynyl group, a $C_3$-$C_{40}$ allyl group, a $C_4$-$C_{40}$ alkyldienyl group, a $C_4$-$C_{40}$ polyenyl group, a $C_2$-$C_{40}$ ketone group, a $C_2$-$C_{40}$ ester group, a $C_6$-$C_{18}$ aryl group, a $C_6$-$C_{40}$ alkylaryl group, a $C_6$-$C_{40}$ arylalkyl group, a $C_4$-$C_{40}$ cycloalkyl group, a $C_4$-$C_{40}$ cycloalkenyl group, and the like. Preferred among the foregoing groups are a $C_1$-$C_{20}$ alkyl group, a $C_1$-$C_{20}$ fluoroalkyl group, a $C_2$-$C_{20}$ alkenyl group, a $C_2$-$C_{20}$ alkynyl group, a $C_3$-$C_{20}$ allyl group, a $C_4$-$C_{20}$ alkyldienyl group, a $C_2$-$C_{20}$ ketone group, a $C_2$-$C_{20}$ ester group, a $C_6$-$C_{12}$ aryl group, and a $C_4$-$C_{20}$ polyenyl group, respectively.

Also included are combinations of groups having carbon atoms and groups having hetero atoms, like e.g. an alkynyl group, preferably ethynyl, that is substituted with a silyl group, preferably a trialkylsilyl group.

The carbyl or hydrocarbyl group may be an acyclic group or a cyclic group. Where the carbyl or hydrocarbyl group is an acyclic group, it may be straight-chain or branched. Where the carbyl or hydrocarbyl group is a cyclic group, it may be a non-aromatic carbocyclic or heterocyclic group, or an aryl or heteroaryl group.

A non-aromatic carbocyclic group as referred to above and below is saturated or unsaturated and preferably has 4 to 30 ring C atoms. A non-aromatic heterocyclic group as referred to above and below preferably has 4 to 30 ring C atoms, wherein one or more of the C ring atoms are optionally replaced by a hetero atom, preferably selected from N, O, S, Si and Se, or by a -S(O)- or $-S(O)_2-$ group. The non-aromatic carbo- and heterocyclic groups are mono- or polycyclic, may also contain fused rings, preferably contain 1, 2, 3 or 4 fused or unfused rings, and are optionally substituted with one or more groups L, wherein

L is selected from halogen, -CN, -NC, -NCO, -NCS, -OCN, -SCN, $-C(=O)NR^0R^{00}$, $-C(=O)X^0$, $-C(=O)R^0$, $-NH_2$, $-NR^0R^{00}$, -SH, $-SR^0$, $-SO_3H$, $-SO_2R^0$, -OH, $-NO_2$, $-CF_3$, $-SF_5$, optionally substituted silyl, or carbyl or hydrocarbyl with 1 to 40 C atoms that is optionally substituted and optionally comprises one or more hetero atoms, and is preferably alkyl, alkoxy, thioalkyl, alkylcarbonyl, alkoxycarbonyl or alkoxycarbonyloxy with 1 to 20 C atoms that is optionally fluorinated,

$X^0$ is halogen, preferably F, Cl or Br, and $R^0$, $R^{00}$ have the meanings given above and below, and preferably denote H or alkyl with 1 to 20 C atoms.

Preferred substituents L are selected from halogen, most preferably F, or alkyl, alkoxy, oxaalkyl, thioalkyl, fluoroalkyl and fluoroalkoxy with 1 to 16 C atoms, or alkenyl or alkynyl with 2 to 20 C atoms.

Preferred non-aromatic carbocyclic or heterocyclic groups are tetrahydrofuran, indane, pyran, pyrrolidine, piperidine, cyclopentane, cyclohexane, cycloheptane, cyclopentanone, cyclohexanone, dihydro-furan-2-one, tetrahydro-pyran-2-one and oxepan-2-one.

An aryl group as referred to above and below preferably has 4 to 30 ring C atoms, is mono- or polycyclic and may also contain fused rings, preferably contains 1, 2, 3 or 4 fused or unfused rings, and is optionally substituted with one or more groups L as defined above.

A heteroaryl group as referred to above and below preferably has 4 to 30 ring C atoms, wherein one or more of the C ring atoms are replaced by a hetero atom, preferably selected from N, O, S, Si and Se, is mono- or polycyclic and may also contain fused rings, preferably contains 1, 2, 3 or 4 fused or unfused rings, and is optionally substituted with one or more groups L as defined above.

As used herein, "arylene" will be understood to mean a divalent aryl group, and "heteroarylene" will be understood to mean a divalent heteroaryl group, including all preferred meanings of aryl and heteroaryl as given above and below.

Preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above. Very preferred rings are selected from pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene, preferably 2-thiophene, selenophene, preferably 2-selenophene, thieno[3,2-b]thiophene, thieno[2,3-b]thiophene, furo[3,2-b]furan, furo[2,3-b]furan, seleno[3,2-b]selenophene, seleno[2,3-b]selenophene, thieno[3,2-b]selenophene, thieno[3,2-b]furan, indole, isoindole, benzo[b]furan, benzo[b]thiophene, benzo[1,2-b;4,5-b']dithiophene, benzo[2,1-b;3,4-b']dithiophene, quinole, 2-methylquinole, isoquinole, quinoxaline, quinazoline, benzotriazole, benzimidazole, benzothiazole, benzisothiazole, benzisoxazole, benzoxadiazole, benzoxazole, benzothiadiazole, 4H-cyclopenta[2,1-b;3,4-b']dithiophene, 7H-3,4-dithia-7-sila-cyclopenta[a]pentalene, all of which can be unsubstituted, mono- or polysubstituted with L as defined above. Further examples of aryl and heteroaryl groups are those selected from the groups shown hereinafter.

An alkyl group or an alkoxy group, *i.e.,* where the terminal $CH_2$ group is replaced by -O-, can be straight-chain or branched, and is preferably straight-chain. It preferably has 2, 3, 4, 5, 6, 7, 8, 10, 12, 14, 16, 18, 20 or 24 carbon atoms and accordingly is preferably ethyl, propyl, butyl, pentyl, hexyl, heptyl, octyl, decyl, dodecyl, tetradecyl, hexadecyl, octadecyl or didecyl, ethoxy, propoxy, butoxy, pentoxy, hexoxy, heptoxy, octoxy, decoxy, dodecoxy, tetradecoxy, hexadecoxy, octadecoxy or didecoxy, furthermore methyl, nonyl, undecyl, tridecyl, pentadecyl, nonoxy, undecoxy or tridecoxy, for example.

An alkenyl group, *i.e.,* wherein one or more $CH_2$ groups are replaced by - CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are $C_2$-$C_7$-1E-alkenyl, $C_4$-$C_7$-3E-alkenyl, $C_5$-$C_7$-4-alkenyl, $C_6$-$C_7$-5-alkenyl and $C_7$-6-alkenyl, in particular $C_2$-$C_7$-1E-alkenyl, $C_4$-$C_7$-3E-alkenyl and $C_5$-$C_7$-4-alkenyl. Examples for particularly preferred alkenyl groups are vinyl, 1E-propenyl, 1E-butenyl, 1E-pentenyl, 1E-hexenyl, 1E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, *i.e.,* where one $CH_2$ group is replaced by -O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one $CH_2$ group is replaced by -O- and one $CH_2$ group is replaced by -C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxyethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonylmethyl, ethoxycarbonylmethyl, propoxycarbonylmethyl, butoxycarbonylmethyl, 2-(methoxycarbonyl)ethyl, 2-(ethoxycarbonyl)ethyl, 2-(propoxycarbonyl)ethyl, 3-(methoxycarbonyl)propyl, 3-(ethoxycarbonyl)propyl, 4-(methoxycarbonyl)-butyl.

An alkyl group wherein two or more $CH_2$ groups are replaced by -O-and/or -C(O)O- can be straight-chain or branched. It is preferably straight-chain and has 3 to 12 C atoms. Accordingly it is preferably bis-carboxymethyl, 2,2-bis-carboxy-ethyl, 3,3-bis-carboxy-propyl, 4,4-bis-carboxybutyl, 5,5-bis-carboxy-pentyl, 6,6-bis-carboxy-hexyl, 7,7-bis-carboxy-heptyl, 8,8-bis-carboxy-octyl, 9,9-bis-carboxy-nonyl, 10,10-bis-carboxydecyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, *i.e.,* where one $CH_2$ group is replaced by -S-, is preferably straight-chain thiomethyl ($-SCH_3$), 1-thioethyl ($-SCH_2CH_3$), 1-thiopropyl (= $-SCH_2CH_2CH_3$), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the $CH_2$ group adjacent to the $sp^2$ hybridised vinyl carbon atom is replaced.

A fluoroalkyl group is perfluoroalkyl $C_iF_{2i+1}$, wherein i is an integer from 1 to 15, in particular $CF_3$, $C_2F_5$, $C_3F_7$, $C_4F_9$, $C_5F_{11}$, $C_6F_{13}$, $C_7F_{15}$ or $C_8F_{17}$, very preferably $C_6F_{13}$, or partially fluorinated alkyl with 1 to 15 C atoms, in particular 1,1-difluoroalkyl, all of which are straight-chain or branched.

Alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 2-ethylhexyl, 2-butylhexyl, 2-ethyloctyl, 2-butyloctly, 2-hexyloctyl, 2-ethyldecyl, 2-butyldecyl, 2-hexyldecyl, 2-octyldecyl, 2-ethyldodecyl, 2-butyldodecyl, 2-hexyldodecyl, 2-octyldodecyl, 2-decyldodecyl, 2-propylpentyl, 3-methylpentyl , 3-ethylpentyl, 3-ethylheptyl, 3-butylheptyl, 3-ethylnonyl, 3-butylnonyl, 3-hexylnonyl, 3-ethylundecyl, 3-butylundecyl, 3-hexylundecyl, 3-octylundecyl, , in particular 2-methylbutyl, 2-methylbutoxy, 2-methylpentoxy, 3-methyl-pentoxy, 2-ethyl-hexoxy, 2-butyloctoxyo, 2-hexyldecoxy, 2-octyldodecoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-methoxy-octoxy, 6-methyloctoxy, 6-methyloctanoyloxy, 5-methylheptyloxy-carbonyl, 2-methylbutyryloxy, 3-methylvaleroyloxy, 4-methylhexanoyloxy, 2-chloro-propionyloxy, 2-chloro-3-methylbutyryloxy, 2-chloro-4-methyl-valeryl-oxy, 2-chloro-3-methylvaleryloxy, 2-methyl-3-oxapentyl, 2-methyl-3-oxa-hexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-ethylhexyl, 2-butylhexyl, 2-ethyloctyl, 2-butyloctly, 2-hexyloctyl, 2-ethyldecyl, 2-butyldecyl, 2-hexyldecyl, 2-octyldecyl, 2-ethyldodecyl, 2-butyldodecyl, 2-hexyldodecyl, 2-octyldodecyl, 2-decyldodecyl, 3-ethylheptyl, 3-butylheptyl, 3-ethylnonyl, 3-butylnonyl, 3-hexylnonyl, 3-ethylundecyl, 3-butylundecyl, 3-hexylundecyl, 3-octylundecyl, 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In a preferred embodiment, the alkyl groups are independently of each other selected from primary, secondary or tertiary alkyl or alkoxy with 1 to 30 C atoms, wherein one or more H atoms are optionally replaced by F, or aryl, aryloxy, heteroaryl or heteroaryloxy that is optionally alkylated or alkoxylated and has 4 to 30 ring atoms. Very preferred groups of this type are selected from the group consisting of the following formulae

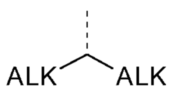
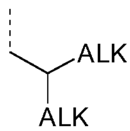
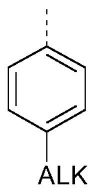
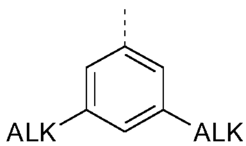

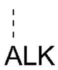
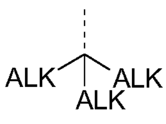
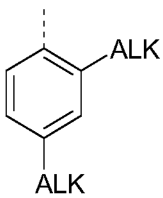
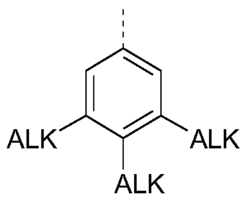

wherein "ALK" denotes optionally fluorinated, preferably linear, alkyl or alkoxy with 1 to 20, preferably 1 to 12 C-atoms, in case of tertiary groups very preferably 1 to 9 C atoms, and the dashed line denotes the link to the ring to which these groups are attached. Especially preferred among these groups are those wherein all ALK subgroups are identical.

As used herein, "halogen" or "hal" includes F, Cl, Br or I, preferably F, Cl or Br.

As used herein, -CO- C=O, -C=O- and -CO- will be understood to mean a carbonyl group, i.e. a group having the structure

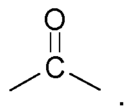

As used herein, $C{=}CR^1R^2$ will be understood to mean an ylidene group, i.e. a group having the structure

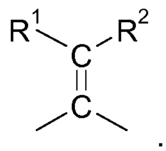

Above and below, $Y^1$ and $Y^2$ are independently of each other H, F, Cl or CN.
Above and below, $R^0$ and $R^{00}$ are independently of each other H or an optionally substituted carbyl or hydrocarbyl group with 1 to 40 C atoms, and preferably denote H or alkyl with 1 to 12 C-atoms.

Detailed Description of the Invention

This invention relates to a new class of compounds expressed by the general structure as shown in formula 11. Apart from being novel, these compounds demonstrate one or more of the following properties:

i) The addition of two ethynyl groups, preferably trialkylsilylethynyl groups, in the 1 and 4 position of the anthracene core helps in solubilising the molecular material in common organic solvents allowing the material to be easily solution processed. The addition of the (trialkylsilyl) ethynyl substituents also promotes the material to exhibit $\pi$-stacking order and thus to form highly organized crystalline films after deposition from solution.

ii) The size of the (trialkylsilyl) ethynyl groups strongly influences the $\pi$-stacking interactions in the solid state. For example, in anthradithiophene based small molecules with small substituent groups where the diameter of the trialkylsilyl group is significantly smaller than half the length of the acene core, a one-dimensional $\pi$-$\pi$-stack or "slipped stack" arrangement is formed. However, when the size of the trialkylsilyl group is approximately the same as half the length of the acene core, a two-dimensional $\pi$-stack or "bricklayer" arrangement is favoured, which has been found to be the optimal for charge transport in FET devices. Therefore, by adding two trialkylsilyl groups of the correct size and in the correct position to the anthracene core, the packing arrangement in the solid state is affected and a preferential $\pi$-stacking can be obtained with a suitably sized trialkylsilyl group.

iii) The non-linear nature of the structure promotes additional solubility thereby allowing the material to be easily solution processed.

iv) The non-linear backbone of the small molecule increases the band-gap compared with the linear equivalent thereby improving the stability of the small molecule.

v) An extended core structure with a larger $\pi$-electron system allows potentially greater $\pi$-$\pi$ overlap between neighbouring molecules within a two-dimensional $\pi$-stack or "bricklayer" arrangement, thus improving the charge carrier mobility

The compounds of the present invention are easy to synthesize and exhibit several advantageous properties, like a high charge carrier mobility, a high melting point, a high solubility in organic solvents, a good processability for the device manufacture process, a high oxidative and photostability and a long lifetime in electronic devices. In addition, they show advantageous properties as discussed above and below.
Preferably, R', R" and R'" in the compounds of formula 11 are each independently selected from optionally substituted and straight-chain, branched or cyclic alkyl or alkoxy having 1 to 10 C atoms, which is for example methyl, ethyl, n-propyl, isopropyl, cyclopropyl, 2,3-dimethylcyclopropyl, 2,2,3,3-tetramethylcyclopropyl, tert-butyl, cyclobutyl, cyclopentyl, methoxy or ethoxy, optionally substituted and straight-chain, branched or cyclic alkenyl, alkynyl or alkylcarbonyl having 2 to 12 C atoms, which is for example allyl, isopropenyl, 2-but-1-enyl, cis-2-but-2-enyl, 3-but-1-enyl, propynyl or acetyl, optionally substituted aryl, heteroaryl, arylalkyl or heteroarylalkyl, aryloxy or heteroaryloxy having 5 to 10 ring atoms, which is for example phenyl, p-tolyl, benzyl, 2-furanyl, 2-thienyl, 2-selenophenyl, N-methylpyrrol-2-yl or phenoxy.
Further preferred is a group AR'R"R'" wherein one or more of R', R" and R'" together with the C, Si or Ge atom

A form a cyclic group, preferably having 2 to 8 C atoms.

In another preferred embodiment, in the groups AR'R"R'" all substituents R', R" and R'" are identical.

In another preferred embodiment, in the groups AR'R"R'" at least two of the substituents R', R" and R'" are not identical. This means that at least one substituent R', R" and R'" has a meaning that is different from the meanings of the other substituents R', R" and R'".

In another preferred embodiment, in the groups AR'R"R'" each of R', R" and R'" has a meaning that is different from the other of R" and R'". Further preferred are groups AR'R"R'" of formula II wherein two of R', R" and R'" have the same meaning and one of R', R" and R'" has a meaning which is different from the other two of R', R" and R'".

Further preferred are groups AR'R"R'" wherein one or more of R', R" and R'" denote or contain an alkenyl group or an aryl or heteroaryl group.

In the compounds of formula 11 and its subformulae A preferably denotes Si.

Preferred compounds of formula 11 are selected from the following formula:

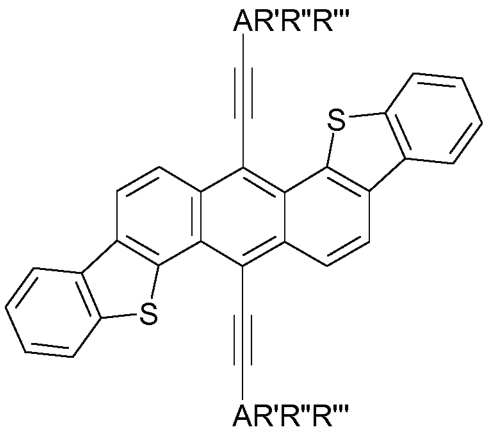

I1

wherein A, R', R" and R'" are as defined in claim 1 or have one of the preferred meanings as given above and below, A is preferably Si, and the benzene rings are optionally substituted by one or more groups $R^S$ as defined above and below.

Very preferred compounds of formula 11 are selected from the following subformulae

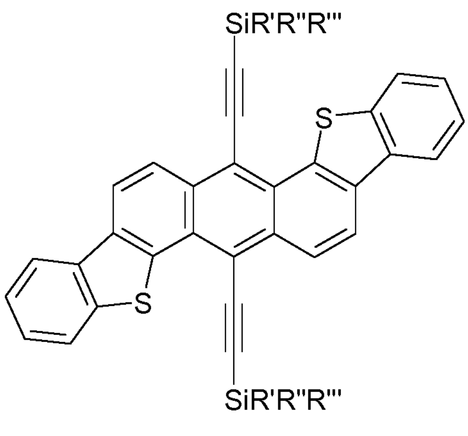

I1a

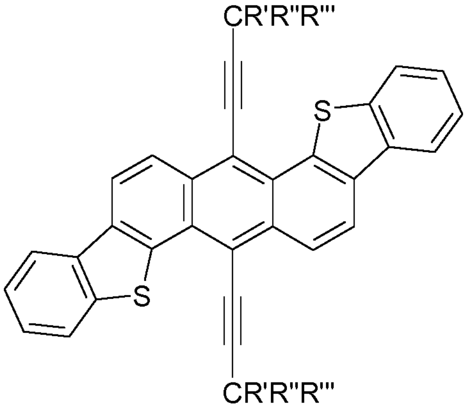

I1b

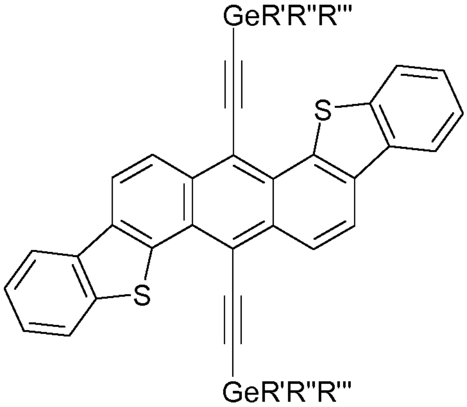

I1c

wherein R’, R" and R’" are as defined in formula I1 or have one of the preferred meanings as given above and below.

Very preferred are compounds of formula I1a.

The compounds of formula I1 can be synthesized according to or in analogy to methods that are known to the skilled person and are described in the literature. Other methods of preparation can be taken from the examples. Especially preferred and suitable synthesis methods are further described below.

A suitable and preferred synthesis route for the compounds of formula 11 is exemplarily shown in Scheme 1 below for the case where A is Si, wherein R’, R" and R’" have the meanings given above and below, and the benzene rings can also be substituted by one or more groups $R^S$ as defined above and below.

Dibenzothiophene-4-carboxylic acid 1 is reacted with N,N-dimethylformamide in the presence of thionyl chloride to form the corresponding dibenzothiophene-4-carboxylic acid amide **2**, which is then reacted with butyllithium at low temperature, preferably -78°C and dimerises to form the corresponding anthraquinone **3**. Reaction of the corresponding substituted silylacetylene **4** with butyllithium provides the substituted lithium silylacetylide, which is reacted with the anthraquinone **3** to give the respective compound **5** of formula 11.

Scheme 1

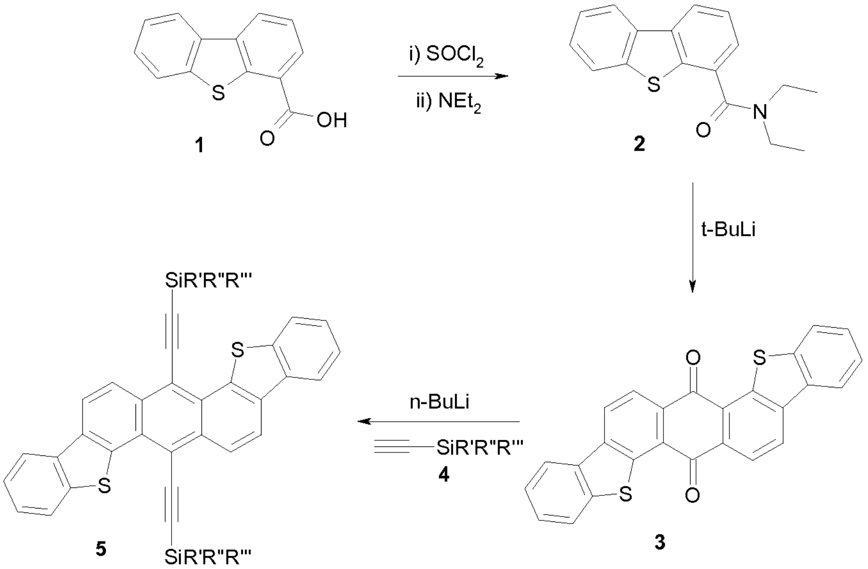

1 2 3 4 5

Further derivatives of formula I1 with different substituents, or wherein the radical A denotes C or Ge, can be synthesised in analogous manner.

The methods to synthesize compounds of formula I1 as described above and below are another object of the invention.

The invention further relates to a composition comprising one or more compounds of formula I1 and one or more binders, preferably selected from organic binders, very preferably from polymeric organic binders.

The invention further relates to a formulation comprising one or more compounds of formula I1, or a composition comprising it, and further comprising one or more solvents, preferably selected from organic solvents.

Preferred solvents are aliphatic hydrocarbons, chlorinated hydrocarbons, aromatic hydrocarbons, ketones, ethers and mixtures thereof. Additional solvents which can be used include 1,2,4-trimethylbenzene, 1,2,3,4-tetramethyl benzene, pentylbenzene, mesitylene, cumene, cymene, cyclo-hexylbenzene, diethylbenzene, tetralin, decalin, 2,6-lutidine, 2-fluoro-m-xylene, 3-fluoro-o-xylene, 2-chlorobenzotrifluoride, dimethylformamide, 2-chloro-6fluorotoluene, 2-fluoroanisole, anisole, 2,3-dimethylpyrazine, 4-fluoroanisole, 3-fluoroanisole, 3-trifluoro-methylanisole, 2-methylanisole, phenetol, 4-methylansiole, 3-methylanisole, 4-fluoro-3-methylanisole, 2-fluorobenzonitrile, 4-fluoroveratrol, 2,6-dimethylanisole, 3-fluorobenzo-nitrile, 2,5-dimethylanisole, 2,4-dimethylanisole, benzonitrile, 3,5-dimethylanisole, N,N-dimethylaniline, ethyl benzoate, 1-fluoro-3,5-dimethoxybenzene, 1-methylnaphthalene, N-methylpyrrolidinone, 3-fluorobenzotrifluoride, benzotrifluoride, benzotrifluoride, diosane, trifluoromethoxy-benzene, 4-fluorobenzotrifluoride, 3-fluoropyridine, toluene, 2-fluorotoluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluorobenzene, 3-chlorofluorobenzene, 1-chloro-2,5-difluorobenzene, 4-chlorofluorobenzene, chlorobenzene, o-dichlorobenzene, 2-chlorofluorobenzene, p-xylene, m-xylene, o-xylene or mixture of o-, m-, and p-isomers. Solvents with relatively low polarity are generally preferred. For inkjet printing solvents with high boiling temperatures and solvent mixtures are preferred. For spin coating alkylated benzenes like xylene and toluene are preferred.

The invention further relates to an organic semiconducting composition comprising one or more compounds of formula I1, one or more organic binders, preferably polymeric organic binders, or precursors thereof, preferably having a permittivity $\varepsilon$ at 1,000 Hz of 3.3 or less, and optionally one or more solvents.

Combining specified soluble compounds of formula I1, especially compounds of the preferred formulae as described above and below, with an organic binder resin (hereinafter also referred to as "the binder") results in little or no reduction in charge mobility of the compounds of formula I1, even an increase in some instances. For instance, the compounds of formula I1 may be dissolved in a binder resin (for example poly($\alpha$-methylstyrene) and deposited (for example by spin coating), to form an organic semiconducting layer yielding a high charge mobility. Moreover, a semiconducting layer formed thereby exhibits excellent film forming characteristics and is particularly stable.

If an organic semiconducting layer composition of high mobility is obtained by combining a compound of formula I1 with a binder, the resulting composition leads to several advantages. For example, since the compounds of formula I1 are soluble they may be deposited in a liquid form, for example from solution. With the additional use of the binder the composition can be coated onto a large area in a highly uniform manner. Furthermore, when a binder is used in the

composition it is possible to control the properties of the composition to adjust to printing processes, for example viscosity, solid content, surface tension. Whilst not wishing to be bound by any particular theory it is also anticipated that the use of a binder in the composition fills in volume between crystalline grains otherwise being void, making the organic semiconducting layer less sensitive to air and moisture. For example, layers formed according to the process of the present invention show very good stability in OFET devices in air.

The invention also provides an organic semiconducting layer which comprises an organic semiconducting compound of formula I1 or the organic semiconducting layer composition comprising it.

The invention further provides a process for preparing an organic semiconducting layer, said process comprising the following steps:

(i) depositing on a substrate a liquid layer of a composition comprising one or more compounds of formula I1 as described above and below, one or more organic binder resins or precursors thereof, and optionally one or more solvents,

(ii) forming from the liquid layer a solid layer which is the organic semiconducting layer,

(iii) optionally removing the layer from the substrate.

The process is described in more detail below.

The invention additionally provides an electronic device comprising the said organic semiconducting layer. The electronic device may include, without limitation, an organic field effect transistor (OFET), organic light emitting diode (OLED), photodetector, sensor, logic circuit, memory element, capacitor or photovoltaic (PV) cell. For example, the active semiconductor channel between the drain and source in an OFET may comprise the layer of the invention. As another example, a charge (hole or electron) injection or transport layer in an OLED device may comprise the layer of the invention. The compositions according to the present invention and layers formed there from have particular utility in OFETs especially in relation to the preferred embodiments described herein.

The semiconducting compound of formula I1 preferably has a charge carrier mobility, $\mu$, of more than 0.001 $cm^2V^{-1}s^{-1}$, very preferably of more than 0.01 $cm^2V^{-1}s^{-1}$, especially preferably of more than 0.1 $cm^2V^{-1}s^{-1}$ and most preferably of more than 0.5 $cm^2V^{-1}s^{-1}$.

The binder, which is typically a polymer, may comprise either an insulating binder or a semiconducting binder, or mixtures thereof may be referred to herein as the organic binder, the polymeric binder or simply the binder.

Preferred binders according to the present invention are materials of low permittivity, that is, those having a permittivity $\varepsilon$ at 1,000 Hz of 3.3 or less. The organic binder preferably has a permittivity $\varepsilon$ at 1,000 Hz of 3.0 or less, more preferably 2.9 or less. Preferably the organic binder has a permittivity $\varepsilon$ at 1,000 Hz of 1.7 or more. It is especially preferred that the permittivity of the binder is in the range from 2.0 to 2.9. Whilst not wishing to be bound by any particular theory it is believed that the use of binders with a permittivity $\varepsilon$ of greater than 3.3 at 1,000 Hz, may lead to a reduction in the OSC layer mobility in an electronic device, for example an OFET. In addition, high permittivity binders could also result in increased current hysteresis of the device, which is undesirable.

An example of a suitable organic binder is polystyrene. Further examples of suitable binders are disclosed for example in US 2007/0102696 A1. Especially suitable and preferred binders are described in the following.

In one type of preferred embodiment, the organic binder is one in which at least 95%, more preferably at least 98% and especially all of the atoms consist of hydrogen, fluorine and carbon atoms.

It is preferred that the binder normally contains conjugated bonds, especially conjugated double bonds and/or aromatic rings.

The binder should preferably be capable of forming a film, more preferably a flexible film. Polymers of styrene and $\alpha$-methyl styrene, for example copolymers including styrene, $\alpha$-methylstyrene and butadiene may suitably be used.

Binders of low permittivity of use in the present invention have few permanent dipoles which could otherwise lead to random fluctuations in molecular site energies. The permittivity $\varepsilon$ (dielectric constant) can be determined by the ASTM D150 test method.

It is also preferred that in the present invention binders are used which have solubility parameters with low polar and hydrogen bonding contributions as materials of this type have low permanent dipoles. A preferred range for the solubility parameters ('Hansen parameter') of a binder for use in accordance with the present invention is provided in Table 1 below.

Table 1

| | Hansen parameter | | |
|---|---|---|---|
| | $\delta_d$ MPa$^{1/2}$ | $\delta_p$ MPa$^{1/2}$ | $\delta_h$ MPa$^{1/2}$ |
| Preferred range | 14.5+ | 0-10 | 0-14 |
| More preferred range | 16+ | 0-9 | 0-12 |
| Most preferred range | 17+ | 0-8 | 0-10 |

The three dimensional solubility parameters listed above include: dispersive ($\delta_d$), polar ($\delta_p$) and hydrogen bonding ($\delta_h$) components (C.M. Hansen, Ind. Eng. and Chem., Prod. Res. and Devl., 9, No3, p282., 1970). These parameters may be determined empirically or calculated from known molar group contributions as described in Handbook of Solubility Parameters and Other Cohesion Parameters ed. A.F.M. Barton, CRC Press, 1991. The solubility parameters of many known polymers are also listed in this publication.

It is desirable that the permittivity of the binder has little dependence on frequency. This is typical of non-polar materials. Polymers and/or copolymers can be chosen as the binder by the permittivity of their substituent groups. A list of suitable and preferred low polarity binders is given (without limiting to these examples) in Table 2:

Table 2

| Binder | typical low frequency permittivity ($\varepsilon$) |
|---|---|
| polystyrene | 2.5 |
| poly($\alpha$-methylstyrene) | 2.6 |
| poly($\alpha$-vinylnaphtalene) | 2.6 |
| poly(vinyltoluene) | 2.6 |
| polyethylene | 2.2-2.3 |
| cis-polybutadiene | 2.0 |
| polypropylene | 2.2 |
| poly(4-methyl-1-pentene) | 2.1 |
| poly (4-methylstyrene) | 2.7 |
| poly(chorotrifluoroethylene) | 2.3-2.8 |
| poly(2-methyl-1,3-butadiene) | 2.4 |
| poly(p-xylylene) | 2.6 |
| poly($\alpha$-$\alpha$-$\alpha$'-$\alpha$' tetrafluoro-p-xylylene) | 2.4 |
| poly[1, 1-(2-methyl propane)bis(4-phenyl)carbonate] | 2.3 |
| poly(cyclohexyl methacrylate) | 2.5 |
| poly(chlorostyrene) | 2.6 |
| poly(2,6-dimethyl-1,4-phenylene ether) | 2.6 |
| polyisobutylene | 2.2 |
| poly(vinyl cyclohexane) | 2.2 |
| poly(vinylcinnamate) | 2.9 |
| poly(4-vinylbiphenyl) | 2.7 |

Further preferred binders are poly(1,3-butadiene) and polyphenylene.

Especially preferred are compositions wherein the binder is selected from poly-$\alpha$-methyl styrene, polystyrene and polytriarylamine or any copolymers of these, and the solvent is selected from xylene(s), toluene, tetralin and cyclohexanone.

Copolymers containing the repeat units of the above polymers are also suitable as binders. Copolymers offer

the possibility of improving compatibility with the compounds of formula 11, modifying the morphology and/or the glass transition temperature of the final layer composition. It will be appreciated that in the above table certain materials are insoluble in commonly used solvents for preparing the layer. In these cases analogues can be used as copolymers. Some examples of copolymers are given in Table 3 (without limiting to these examples). Both random or block copolymers can be used. It is also possible to add more polar monomer components as long as the overall composition remains low in polarity.

Table 3

| Binder | typical low frequency permittivity (ε) |
|---|---|
| poly(ethylene/tetrafluoroethylene) | 2.6 |
| poly(ethylene/chlorotrifluoroethylene) | 2.3 |
| fluorinated ethylene/propylene copolymer | 2-2.5 |
| polystyrene-co-α-methylstyrene | 2.5-2.6 |
| ethylene/ethyl acrylate copolymer | 2.8 |
| poly(styrene/10%butadiene) | 2.6 |
| poly(styrene/15%butadiene) | 2.6 |
| poly(styrene/2,4 dimethylstyrene) | 2.5 |
| Topas™ (all grades) | 2.2-2.3 |

Other copolymers may include: branched or non-branched polystyrene-block-polybutadiene, polystyrene-block(polyethylene-ran-butylene)-block-polystyrene, polystyrene-block-polybutadiene-block-polystyrene, polystyrene-(ethylene-propylene)-diblock-copolymers (e.g. KRATON®-G1701E, Shell), poly(propylene-co-ethylene) and poly(styrene-co-methyl methacrylate).

Preferred insulating binders for use in the organic semiconductor layer composition according to the present invention are poly(α-methylstyrene), polyvinylcinnamate, poly(4-vinylbiphenyl), poly(4-methylstyrene), and Topas™ 8007 (linear olefin, cyclo- olefin(norbornene) copolymer available from Ticona, Germany). Most preferred insulating binders are poly(α-methylstyrene), polyvinylcinnamate and poly(4-vinylbiphenyl).

The binder can also be selected from crosslinkable binders, like e.g. acrylates, epoxies, vinylethers, thiolenes etc., preferably having a sufficiently low permittivity, very preferably of 3.3 or less. The binder can also be mesogenic or liquid crystalline.

As mentioned above the organic binder may itself be a semiconductor, in which case it will be referred to herein as a semiconducting binder. The semiconducting binder is still preferably a binder of low permittivity as herein defined. Semiconducting binders for use in the present invention preferably have a number average molecular weight ($M_n$) of at least 1500-2000, more preferably at least 3000, even more preferably at least 4000 and most preferably at least 5000. The semiconducting binder preferably has a charge carrier mobility, μ, of at least $10^{-5} cm^2V^{-1}s^{-1}$, more preferably at least $10^{-4} cm^2V^{-1}s^{-1}$.

A preferred class of semiconducting binder is a polymer as disclosed in US 6,630,566, preferably an oligomer or polymer having repeat units of formula 1:

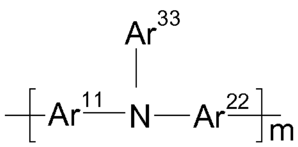

1

wherein

Ar11, Ar22 and Ar33 which may be the same or different, denote, independently if in different repeat units, an optionally substituted aromatic group that is mononuclear or polynuclear, and

m is an integer ≥ 1, preferably ≥ 6, preferably ≥ 10, more preferably ≥ 15 and most preferably ≥ 20.

In the context of $Ar^{11}$, $Ar^{22}$ and $Ar^{33}$, a mononuclear aromatic group has only one aromatic ring, for example

phenyl or phenylene. A polynuclear aromatic group has two or more aromatic rings which may be fused (for example napthyl or naphthylene), individually covalently linked (for example biphenyl) and/or a combination of both fused and individually linked aromatic rings. Preferably each $Ar^{11}$, $Ar^{22}$ and $Ar^{33}$ is an aromatic group which is substantially conjugated over substantially the whole group.

Further preferred classes of semiconducting binders are those containing substantially conjugated repeat units. The semiconducting binder polymer may be a homopolymer or copolymer (including a block-copolymer) of the general formula 2:

$$A_{(c)}B_{(d)}...Z_{(z)} \qquad 2$$

wherein A, B,...,Z each represent a monomer unit and (c), (d),...(z) each represent the mole fraction of the respective monomer unit in the polymer, that is each (c), (d),...(z) is a value from 0 to 1 and the total of (c) + (d) +...+ (z) = 1.

Examples of suitable and preferred monomer units A, B,...Z include units of formula 1 above and of formulae 3 to 8 given below (wherein m is as defined in formula 1:

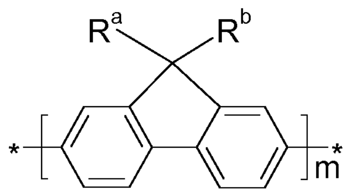

3

wherein m is as defined above and

$R^a$ and $R^b$ are independently of each other selected from H, F, CN, $NO_2$, $-N(R^c)(R^d)$ or optionally substituted alkyl, alkoxy, thioalkyl, acyl, aryl,

$R^c$ and $R^d$ are independently or each other selected from H, optionally substituted alkyl, aryl, alkoxy or polyalkoxy or other substituents,

and wherein the asterisk (*) is any terminal or end capping group including H, and the alkyl and aryl groups are optionally fluorinated;

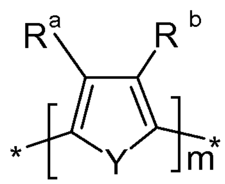

4

wherein m is as defined above and

Y is Se, Te, O, S or $-N(R^e)-$, preferably O, S or $-N(R^e)-$,

$R^e$ is H, optionally substituted alkyl or optionally substituted aryl,

$R^a$ and $R^b$ are as defined in formula 3;

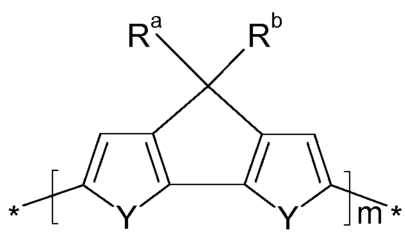

5

wherein $R^a$, $R^b$ and Y are as defined in formulae 3 and 4 and m is as defined in formula 1;

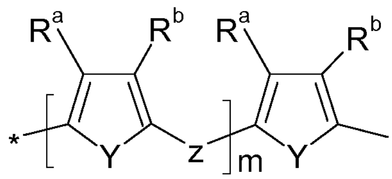

6

wherein $R^a$, $R^b$ and Y are as defined in formulae 3 and 4 and m is as defined in formula 1,

Z is $-C(T^1)=C(T^2)-$, $-C\equiv C-$, $-N(R^f)-$, $-N=N-$, $(R^f)=N-$, $-N=C(R^f)-$,

$T^1$ and $T^2$ independently of each other denote H, Cl, F, -CN or alkyl with 1 to 8 C atoms,

$R^f$ is H or optionally substituted alkyl or aryl;

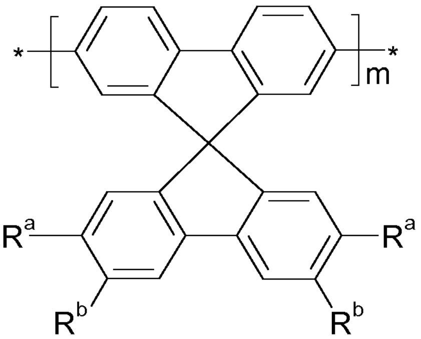

7

wherein $R^a$ and $R^b$ are as defined in formula 3 and m is as defined in formula 1;

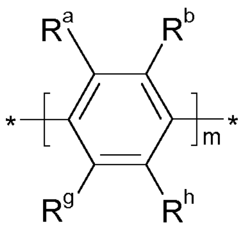

8

wherein $R^a$, $R^b$, $R^g$ and $R^h$ independently of each other have one of the meanings of $R^a$ and $R^b$ in formula 3 and m is as defined in formula 1.

In the case of the polymeric formulae described herein, such as formulae 1 to 8, the polymers may be terminated by any terminal group, that is any end-capping or leaving group, including H.

In the case of a block-copolymer, each monomer A, B,...Z may be a conjugated oligomer or polymer comprising a number, for example 2 to 50, of the units of formulae 3-8. The semiconducting binder preferably includes: arylamine, fluorene, thiophene, spirobifluorene and/or optionally substituted aryl (for example phenylene) groups, more preferably arylamine, most preferably triarylamine groups. The aforementioned groups may be linked by further conjugating groups, for example vinylene.

In addition, it is preferred that the semiconducting binder comprises a polymer (either a homo-polymer or copolymer, including block-copolymer) containing one or more of the aforementioned arylamine, fluorene, thiophene and/or optionally substituted aryl groups. A preferred semiconducting binder comprises a homo-polymer or copolymer (including block-copolymer) containing arylamine (preferably triarylamine) and/or fluorene units. Another preferred semiconducting binder comprises a homo-polymer or co-polymer (including block-copolymer) containing fluorene and/or thiophene units.

The semiconducting binder may also contain carbazole or stilbene repeat units. For example, polyvinylcarbazole, polystilbene or their copolymers may be used. The semiconducting binder may optionally contain DBBDT segments (for example repeat units as described for formula 1 above) to improve compatibility with the soluble compounds of

formula.

Very preferred semiconducting binders for use in the organic semiconductor composition according to the present invention are poly(9-vinylcarbazole) and PTAA1, a polytriarylamine of the following formula

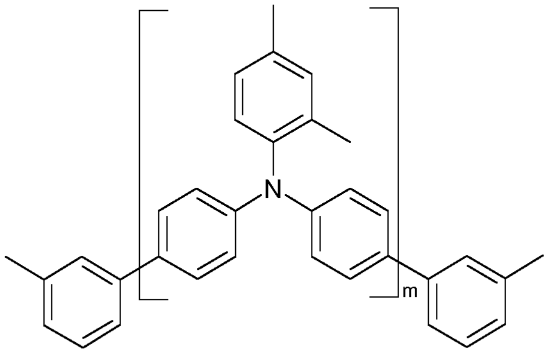

wherein m is as defined in formula 1.

For application of the semiconducting layer in p-channel FETs, it is desirable that the semiconducting binder should have a higher ionisation potential than the semiconducting compound of formula 11, otherwise the binder may form hole traps. In n-channel materials the semiconducting binder should have lower electron affinity than the n-type semiconductor to avoid electron trapping.

The composition according to the present invention may be prepared by a process which comprises:

(i) first mixing a compound of formula I1 and an organic binder or a precursor thereof. Preferably the mixing comprises mixing the two components together in a solvent or solvent mixture,

(ii) applying the solvent(s) containing the compound of formula I1 and the organic binder to a substrate; and optionally evaporating the solvent(s) to form a solid organic semiconducting layer according to the present invention,

(iii) and optionally removing the solid layer from the substrate or the substrate from the solid layer.

In step (i) the solvent may be a single solvent or the compound of formula I1 and the organic binder may each be dissolved in a separate solvent followed by mixing the two resultant solutions to mix the compounds.

The binder may be formed *in situ* by mixing or dissolving a compound of formula I1 in a precursor of a binder, for example a liquid monomer, oligomer or crosslinkable polymer, optionally in the presence of a solvent, and depositing the mixture or solution, for example by dipping, spraying, painting or printing it, on a substrate to form a liquid layer and then curing the liquid monomer, oligomer or crosslinkable polymer, for example by exposure to radiation, heat or electron beams, to produce a solid layer. If a preformed binder is used it may be dissolved together with the compound of formula 11 in a suitable solvent, and the solution deposited for example by dipping, spraying, painting or printing it on a substrate to form a liquid layer and then removing the solvent to leave a solid layer. It will be appreciated that solvents are chosen which are able to dissolve both the binder and the compound of formula I1, and which upon evaporation from the solution blend give a coherent defect free layer.

Suitable solvents for the binder or the compound of formula I1 can be determined by preparing a contour diagram for the material as described in ASTM Method D 3132 at the concentration at which the mixture will be employed. The material is added to a wide variety of solvents as described in the ASTM method.

It will also be appreciated that in accordance with the present invention the composition may also comprise two or more compounds of formula I1 and/or two or more binders or binder precursors, and that the process for preparing the composition may be applied to such compositions.

Examples of suitable and preferred organic solvents include, without limitation, dichloromethane, trichloromethane, monochlorobenzene, o-dichlorobenzene, tetrahydrofuran, anisole, morpholine, toluene, o-xylene, m-xylene, p-xylene, mesitylene, 1,4-dioxane, acetone, 1-methylnaphthalene, methylethylketone, 1,2-dichloroethane, 1,1,1-trichloroethane, 1,1,2,2-tetrachloroethane, ethyl acetate, n-butyl acetate, dimethylformamide, dimethylacetamide, dimethylsulfoxide, tetralin, decalin, indane and/or mixtures thereof.

After the appropriate mixing and ageing, solutions are evaluated as one of the following categories: complete solution, borderline solution or insoluble. The contour line is drawn to outline the solubility parameter-hydrogen bonding limits dividing solubility and insolubility. 'Complete' solvents falling within the solubility area can be chosen from literature values such as published in "Crowley, J.D., Teague, G.S. Jr and Lowe, J.W. Jr., Journal of Paint Technology, 1966,

38( 496), 296 ". Solvent blends may also be used and can be identified as described in "Solvents, W.H.Ellis, Federation of Societies for Coatings Technology, p9-10, 1986". Such a procedure may lead to a blend of 'non' solvents that will dissolve both the binder and the compound of formula I1, although it is desirable to have at least one true solvent in a blend.

Especially preferred solvents for use in the composition according to the present invention, with insulating or semiconducting binders and mixtures thereof, are xylene(s), toluene, tetralin and o-dichlorobenzene.

The proportions of binder to the compound of formula I1 in the composition or layer according to the present invention are typically 20:1 to 1:20 by weight, preferably 10:1 to 1:10 more preferably 5:1 to 1:5, still more preferably 3:1 to 1:3 further preferably 2:1 to 1:2 and especially 1:1. Surprisingly and beneficially, dilution of the compound of formula 11 in the binder has been found to have little or no detrimental effect on the charge mobility, in contrast to what would have been expected from the prior art.

In accordance with the present invention it has further been found that the level of the solids content in the organic semiconducting layer composition is also a factor in achieving improved mobility values for electronic devices such as OFETs. The solids content of the composition is commonly expressed as follows:

$$\text{Solids content (\%)} = \frac{a+b}{a+b+c} \times 100$$

wherein *a* = mass of compound of formula I1, *b* = mass of binder and c = mass of solvent.

In a formulation comprising a compound of formula I1 or a binder composition comprising it and one or more solvents, the solids content is preferably 0.1 to 10% by weight, more preferably 0.5 to 5% by weight. The compounds according to the present invention can also be used in mixtures or blends, for example together with other compounds having charge-transport, semiconducting, electrically conducting, photoconducting and/or light emitting semiconducting properties. Thus, another aspect of the invention relates to a mixture or blend comprising one or more compounds of formula I1 and one or more further compounds having one or more of the above-mentioned properties. These mixtures can be prepared by conventional methods that are described in prior art and known to the skilled person. Typically the compounds are mixed with each other or dissolved in suitable solvents and the solutions combined.

The compositions and formulations according to the present invention can additionally comprise one or more further components like for example surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors.

It is desirable to generate small structures in modern microelectronics to reduce cost (more devices/unit area), and power consumption. Patterning of the layer of the invention may be carried out by photolithography or electron beam lithography.

Liquid coating of organic electronic devices such as field effect transistors is more desirable than vacuum deposition techniques. The formulations of the present invention enable the use of a number of liquid coating techniques. The organic semiconductor layer may be incorporated into the final device structure by, for example and without limitation, dip coating, spin coating, ink jet printing, letter-press printing, screen printing, doctor blade coating, roller printing, reverse-roller printing, offset lithography printing, flexographic printing, web printing, spray coating, brush coating or pad printing. The present invention is particularly suitable for use in spin coating the organic semiconductor layer into the final device structure. Selected formulations of the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments Toshiba TEC or single nozzle microdispensers such as those produced by Microdrop and Microfab may be used.

In order to be applied by ink jet printing or microdispensing, the mixture of the compound of formula I1 and the binder should be first dissolved in a suitable solvent. Solvents must fulfil the requirements stated above and must not have any detrimental effect on the chosen print head.

Additionally, solvents should have boiling points >100°C, preferably >140°C and more preferably >150°C in order to prevent operability problems caused by the solution drying out inside the print head. Suitable solvents include substituted and non-substituted xylene derivatives, di-$C_{1-2}$-alkyl formamide, substituted and non-substituted anisoles and other phenol-ether derivatives, substituted heterocycles such as substituted pyridines, pyrazines, pyrimidines, pyrrolidinones, substituted and non-substituted *N,N*-di-$C_{1-2}$-alkylanilines and other fluorinated or chlorinated aromatics.

A preferred solvent for depositing a formulation according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total.

Such a solvent enables an ink jet fluid to be formed comprising the solvent with the binder and the compound of formula I1 which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is mixture of solvent, binder and semiconducting compound) preferably has a viscosity at 20°C of 1 to 100 mPas, more preferably 1 to 50 mPa·s and most preferably 1 to 30 mPa·s.

The use of the binder in the present invention allows tuning the viscosity of the coating solution, to meet the requirements of particular print heads.

The semiconducting layer of the present invention is typically at most 1 micron (=1μm) thick, although it may be thicker if required. The exact thickness of the layer will depend, for example, upon the requirements of the electronic device in which the layer is used. For use in an OFET or OLED, the layer thickness may typically be 500 nm or less.

In the semiconducting layer of the present invention there may be used two or more different compounds of formula I. Additionally or alternatively, in the semiconducting layer there may be used two or more organic binders of the present invention.

As mentioned above, the invention further provides a process for preparing the organic semiconducting layer which comprises (i) depositing on a substrate a liquid layer of a formulation which comprises one or more compounds of formula I1, one or more organic binders or precursors thereof and optionally one or more solvents, and (ii) forming from the liquid layer a solid layer which is the organic semiconducting layer.

In the process, the solid layer may be formed by evaporation of the solvent and/or by reacting the binder resin precursor (if present) to form the binder resin in situ. The substrate may include any underlying device layer, electrode or separate substrate such as silicon wafer or polymer substrate for example.

In a particular embodiment of the present invention, the binder may be alignable, for example capable of forming a liquid crystalline phase. In that case the binder may assist alignment of the compound of formula I1, for example such that their aromatic core is preferentially aligned along the direction of charge transport. Suitable processes for aligning the binder include those processes used to align polymeric organic semiconductors and are described in prior art, for example in US 2004/0248338 A1.

The composition or formulation according to the present invention can additionally comprise one or more further components like for example surface-active compounds, lubricating agents, wetting agents, dispersing agents, hydrophobing agents, adhesive agents, flow improvers, defoaming agents, deaerators, diluents, reactive or non-reactive diluents, auxiliaries, colourants, dyes or pigments, furthermore, especially in case crosslinkable binders are used, catalysts, sensitizers, stabilizers, inhibitors, chain-transfer agents or co-reacting monomers.

The present invention also provides the use of the semiconducting compound, composition or layer in an electronic device. The composition may be used as a high mobility semiconducting material in various devices and apparatus. The composition may be used, for example, in the form of a semiconducting layer or film. Accordingly, in another aspect, the present invention provides a semiconducting layer for use in an electronic device, the layer comprising the composition according to the invention. The layer or film may be less than about 30 microns. For various electronic device applications, the thickness may be less than about 1 micron thick. The layer may be deposited, for example on a part of an electronic device, by any of the aforementioned solution coating or printing techniques.

The compounds and compositions according to the present invention are useful as charge transport, semiconducting, electrically conducting, photoconducting or light emitting materials in optical, electrooptical, electronic, electroluminescent or photoluminescent components or devices. Especially preferred devices are OFETs, TFTs, ICs, logic circuits, capacitors, RFID tags, OLEDs, OLETs, OPEDs, OPVs, solar cells, laser diodes, photoconductors, photodetectors, electrophotographic devices, electrophotographic recording devices, organic memory devices, sensor devices, charge injection layers, Schottky diodes, planarising layers, antistatic films, conducting substrates and conducting patterns. In these devices, the compounds of the present invention are typically applied as thin layers or films.

For example, the compound or composition may be used as a layer or film, in a field effect transistor (FET) for example as the semiconducting channel, organic light emitting diode (OLED) for example as a hole or electron injection or transport layer or electroluminescent layer, photodetector, chemical detector, photovoltaic cell (PVs), capacitor sensor, logic circuit, display, memory device and the like. The compound or composition may also be used in electrophotographic (EP) apparatus.

The compound or composition is preferably solution coated to form a layer or film in the aforementioned devices or apparatus to provide advantages in cost and versatility of manufacture. The improved charge carrier mobility of the compound or composition of the present invention enables such devices or apparatus to operate faster and/or more efficiently.

Especially preferred electronic device are OFETs, OLEDs and OPV devices, in particular bulk heterojunction (BHJ) OPV devices. In an OFET, for example, the active semiconductor channel between the drain and source may

comprise the layer of the invention. As another example, in an OLED device, the charge (hole or electron) injection or transport layer or an emitting layer may comprise the layer of the invention.

For use in OPV devices the small molecule according to the present invention is preferably used in a composition that comprises or contains, more preferably consists essentially of, very preferably exclusively of, a p-type (electron donor) semiconductor and an n-type (electron acceptor) semiconductor. The p-type semiconductor is constituted by a compound according to the present invention. The n-type semiconductor can be an inorganic material such as zinc oxide or cadmium selenide, or an organic material such as a fullerene derivate, for example (6,6)-phenyl-butyric acid methyl ester derivatized methano $C_{60}$ fullerene, also known as "PCBM" or "$C_{60}$PCBM", as disclosed for example in G. Yu, J. Gao, J.C. Hummelen, F. Wudl, A.J. Heeger, Science 1995, 270, 1789 ff and having the structure shown below, or an structural analogous compound with e.g. a $C_{70}$ fullerene group ($C_{70}$PCBM), or a polymer (see for example Coakley, K. M. and McGehee, M. D. Chem. Mater. 2004, 16, 4533).

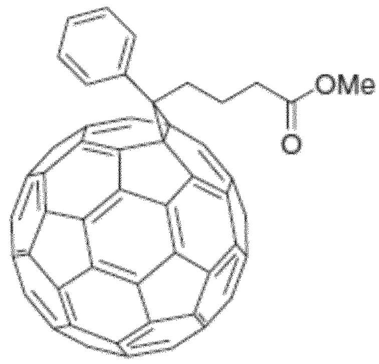

$C_{60}$PCBM

A preferred material of this type is a blend or mixture of an acene compound according to the present invention with a $C_{60}$ or $C_{70}$ fullerene or modified fullerene like PCBM. Preferably the ratio acene:fullerene is from 2:1 to 1:2 by weight, more preferably from 1.2:1 to 1:1.2 by weight, most preferably 1:1 by weight. For the blended mixture, an optional annealing step may be necessary to optimize blend morpohology and consequently OPV device performance.

The OPV device can for example be of any type known from the literature [see e.g. Waldauf et al., Appl. Phys. Lett., 2006, 89, 233517].

A first preferred OPV device according to the invention comprises:

- a low work function electrode (for example a metal, such as aluminum), and a high work function electrode (for example ITO), one of which is transparent,
- a layer (also referred to as "active layer") comprising a hole transporting material and an electron transporting material, preferably selected from OSC materials, situated between the electrodes; the active layer can exist for example as a bilayer or two distinct layers or blend or mixture of p-type and n-type semiconductor, forming a bulk heterjunction (BHJ) (see for example Coakley, K. M. and McGehee, M. D. Chem. Mater. 2004, 16, 4533),
- an optional conducting polymer layer, for example comprising a blend of PEDOT:PSS (poly(3,4-ethylenedioxythiophene):poly(styrenesulfonate)), situated between the active layer and the high work function electrode, to modify the work function of the high work function electrode to provide an ohmic contact for holes,
- an optional coating (for example of LiF) on the side of the low workfunction electrode facing the active layer, to provide an ohmic contact for electrons.

A second preferred OPV device according to the invention is an inverted OPV device and comprises:

- a low work function electrode (for example a metal, such as gold), and a high work function electrode (for example ITO), one of which is transparent,
- a layer (also referred to as "active layer") comprising a hole transporting material and an electron transporting material, preferably selected from OSC materials, situated between the electrodes; the active layer can exist for example as a bilayer or two distinct layers or blend or mixture of p-type and n-type semiconductor, forming a BHJ,
- an optional conducting polymer layer, for example comprising a blend of PEDOT:PSS, situated between the active layer and the low work function electrode to provide an ohmic contact for electrons,
- an optional coating (for example of $TiO_x$) on the side of the high workfunction electrode facing the active layer, to provide an ohmic contact for holes.

In the OPV devices of the presentinvention the p-type and n-type semiconductor materials are preferably selected from the materials, like the p-type compound/fullerene systems, as described above. If the bilayer is a blend an optional annealing step may be necessary to optimize device performance.

The compound, composition and layer of the present invention are also suitable for use in an OFET as the semiconducting channel. Accordingly, the invention also provides an OFET comprising a gate electrode, an insulating (or gate insulator) layer, a source electrode, a drain electrode and an organic semiconducting channel connecting the source and drain electrodes, wherein the organic semiconducting channel comprises a compound, composition or organic semiconducting layer according to the present invention. Other features of the OFET are well known to those skilled in the art.

OFETs where an OSC material is arranged as a thin film between a gate dielectric and a drain and a source electrode, are generally known, and are described for example in US 5,892,244, US 5,998,804, US 6,723,394 and in the references cited in the background section. Due to the advantages, like low cost production using the solubility properties of the compounds according to the invention and thus the processibility of large surfaces, preferred applications of these FETs are such as integrated circuitry, TFT displays and security applications.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

An OFET device according to the present invention preferably comprises:

- a source electrode,
- a drain electrode,
- a gate electrode,
- a semiconducting layer,
- one or more gate insulator layers,
- optionally a substrate.

wherein the semiconductor layer preferably comprises a compound or composition as described above and below.

The OFET device can be a top gate device or a bottom gate device. Suitable structures and manufacturing methods of an OFET device are known to the skilled in the art and are described in the literature, for example in US 2007/0102696 A1.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoro-polymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric content) from 1.0 to 5.0, very preferably from 1.8 to 4.0 ("low k materials"), as disclosed for example in US 2007/0102696 A1 or US 7,095,044.

In security applications, OFETs and other devices with semiconducting materials according to the present invention, like transistors or diodes, can be used for RFID tags or security markings to authenticate and prevent counterfeiting of documents of value like banknotes, credit cards or ID cards, national ID documents, licenses or any product with monetary value, like stamps, tickets, shares, cheques etc.

Alternatively, the materials according to the invention can be used in OLEDs, e.g. as the active display material in a flat panel display applications, or as backlight of a flat panel display like e.g. a liquid crystal display. Common OLEDs are realized using multilayer structures. An emission layer is generally sandwiched between one or more electron-transport and/ or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/ or in the emission layer, corresponding to their electrical and/ or optical properties. Furthermore their use within the emission layer is especially advantageous, if the compounds, materials and films according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Müller, Synth. Metals, 2000, 111-112, 31, Alcala, J. Appl. Phys., 2000, 88, 7124 and the literature cited therein.

According to another use, the materials according to this invention, especially those showing photoluminescent properties, may be employed as materials of light sources, e.g. in display devices, as described in EP 0889350 A1 or

by C. Weder et al., Science, 1998, 279, 835.

A further aspect of the invention relates to both the oxidised and reduced form of the compounds according to this invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., $I_2$, $Cl_2$, $Br_2$, ICl, $ICl_3$, IBr and IF), Lewis acids (e.g., $PF_5$, AsFs, $SbF_5$, $BF_3$, $BCl_3$, $SbCl_5$, $BBr_3$ and $SO_3$), protonic acids, organic acids, or amino acids (e.g., HF, HCl, $HNO_3$, $H_2SO_4$, $HClO_4$, $FSO_3H$ and $ClSO_3H$), transition metal compounds (e.g., $FeCl_3$, FeOCl, $Fe(ClO_4)_3$, $Fe(4\text{-}CH_3C_6H_4SO_3)_3$, $TiCl_4$, $ZrCl_4$, $HfCl_4$, $NbF_5$, $NbCl_5$, $TaCl_5$, $MoF_5$, $MoCl_5$, $WF_5$, $WCl_6$, $UF_6$ and $LnCl_3$ (wherein Ln is a lanthanoid), anions (e.g., $Cl^-$, $Br^-$, $I^-$, $I_3^-$, $HSO_4^-$, $SO_4^{2-}$, $NO_3^-$, $ClO_4^-$, $BF_4^-$, $PF_6^-$, $AsF_6^-$, $SbF_6^-$, $FeCl_4^-$, $Fe(CN)_6^{3-}$, and anions of various sulfonic acids, such as aryl-$SO_3^-$). When holes are used as carriers, examples of dopants are cations (e.g., $H^+$, $Li^+$, $Na^+$, $K^+$, $Rb^+$ and $Cs^+$), alkali metals (e.g., Li, Na, K, Rb, and Cs), alkaline-earth metals (e.g., Ca, Sr, and Ba), $O_2$, $XeOF_4$, $(NO_2^+)$ $(SbF_6^-)$, $(NO_2^+)$ $(SbCl_6^-)$, $(NO_2^+)$ $(BF_4^-)$, $AgClO_4$, $H_2IrCl_6$, $La(NO_3)_3 \cdot 6H_2O$, $FSO_2OOSO_2F$, Eu, acetylcholine, $R_4N^+$, (R is an alkyl group), $R_4P^+$ (R is an alkyl group), $R_6As^+$ (R is an alkyl group), and $R_3S^+$ (R is an alkyl group).

The conducting form of the compounds of the present invention can be used as an organic "metal" in applications including, but not limited to, charge injection layers and ITO planarising layers in OLED applications, films for flat panel displays and touch screens, antistatic films, printed conductive substrates, patterns or tracts in electronic applications such as printed circuit boards and condensers.

The compounds and compositions according to the present invention may also be suitable for use in organic plasmon-emitting diodes (OPEDs), as described for example in Koller et al., Nat. Photonics, 2008, 2, 684.

According to another use, the materials according to the present invention can be used alone or together with other materials in or as alignment layers in LCD or OLED devices, as described for example in US 2003/0021913. The use of charge transport compounds according to the present invention can increase the electrical conductivity of the alignment layer. When used in an LCD, this increased electrical conductivity can reduce adverse residual dc effects in the switchable LCD cell and suppress image sticking or, for example in ferroelectric LCDs, reduce the residual charge produced by the switching of the spontaneous polarisation charge of the ferroelectric LCs. When used in an OLED device comprising a light emitting material provided onto the alignment layer, this increased electrical conductivity can enhance the electroluminescence of the light emitting material. The compounds or materials according to the present invention having mesogenic or liquid crystalline properties can form oriented anisotropic films as described above, which are especially useful as alignment layers to induce or enhance alignment in a liquid crystal medium provided onto said anisotropic film. The materials according to the present invention may also be combined with photoisomerisable compounds and/or chromophores for use in or as photoalignment layers, as described in US 2003/0021913.

According to another use, the materials according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A. 1999, 96, 12287; D. Wang, X. Gong, P. S. Heeger, F. Rininsland, G. C. Bazan and A. J. Heeger, Proc. Natl. Acad. Sci. U.S.A. 2002, 99, 49; N. DiCesare, M. R. Pinot, K. S. Schanze and J. R. Lakowicz, Langmuir 2002, 18, 7785; D. T. McQuade, A. E. Pullen, T. M. Swager, Chem. Rev. 2000, 100, 2537.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

The invention will now be described in more detail by reference to the following examples, which are illustrative only and do not limit the scope of the invention.

Unless stated otherwise, above and below percentages are per cent by weight and temperatures are given in degrees Celsius.

Examples

Example 1 - Compound B

Dibenzothiophene-4-carboxylic acid diethylamide

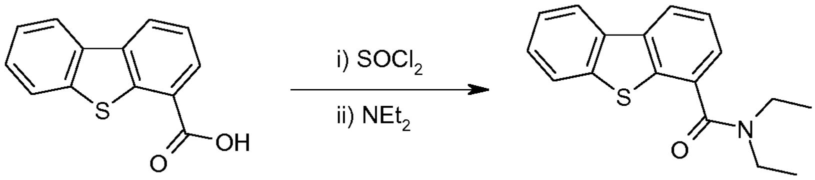


To a mixture of dibenzothiophene-4-carboxylic acid (10.0 g, 44 mmol) and anhydrous dichloromethane (150 $cm^3$) is added thionyl chloride (6.4 $cm^3$, 88 mmol) and dropwise anhydrous *N*,*N*-dimethylformamide (3.4 $cm^3$, 44 mmol). After addition, the mixture is heated at reflux for 17 hours. The mixture cooled and the volatiles removed *in vacuo.* The residue taken up in anhydrous ether (150 $cm^3$) and diethylamine (14 $cm^3$, 130 mmol) added. The mixture is then stirred at 23 °C for 17 hours. Water (100 $cm^3$) is added and the organics are extracted with dichloromethane (2 x 100 $cm^3$). The combined organics are dried over anhydrous magnesium sulfate, filtered and the solvent removed *in vacuo.* The crude is passed through a plug of silica (1:1; dichloromethane:ether) to give dibenzothiophene-4-carboxylic acid diethylamide (9.6 g, 77%) as an off-white crystalline solid. $^1$H-NMR (300 MHz, $CDCl_3$) 0.94 - 1.51 (6H, br m), 3.13 - 3.82 (4H, br m), 7.41 - 7.53 (4H, m), 7.82 - 7.89 (1H, m), 8.13 - 8.20 (2H, m).

Compound A

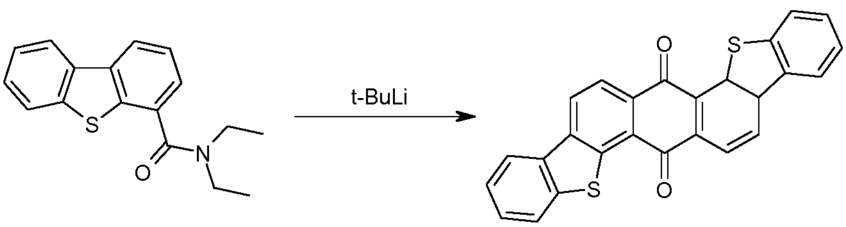


To a solution of dibenzothiophene-4-carboxylic acid diethylamide (45.9 g, 162 mmol) in anhydrous tetrahydrofuran (1500 $cm^3$) at -78 °C is added dropwise *t*-butyllithium (100 $cm^3$, 170 mmol) over 30 minutes. The mixture is then stirred at -78 °C for 60 minutes and at 23 °C for 17 hours. The mixture is poured into water (1 $dm^3$) and stirred for 30 minutes. The solid is collected by filtration and triturated in hot dichloromethane (150 $cm^3$). The mixture allowed to cool, the solid collected by filtration and washed with dichloromethane (50 $cm^3$) to give compound A (890 mg, 2%) as a yellow solid. $^1$H-NMR (300 MHz, o-dichlorobenzene at 120 °C) 7.27 - 7.42 (4H, m), 7.75 - 7.81 (2H, m), 8.00 - 8.05 (2H, m), 8.26 (2H, d, J 8.2), 8.36 (2H, d, J 8.2).

Compound B

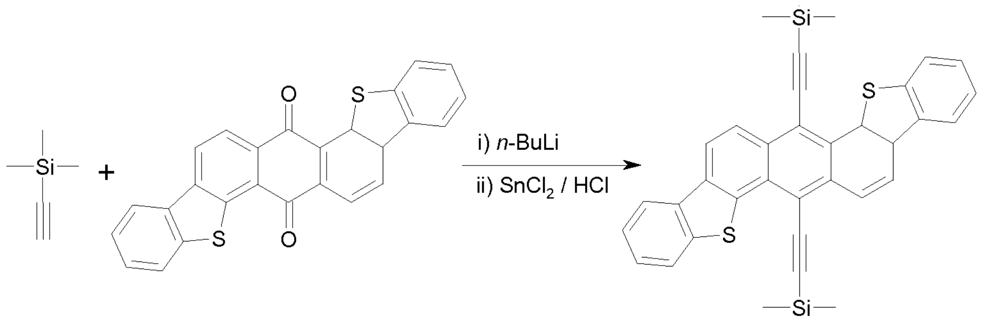


To a solution of (trimethylsilyl)acetylene (1.34 $cm^3$, 9.5 mmol) in anhydrous tetrahydrofuran (40 $cm^3$) at 0 °C is added dropwise n-butyllithium (3.4 $cm^3$, 8.6 mmol, 2.5 M). After addition, the mixture is stirred at 0 °C for 5 minutes and then at 23 °C for 30 minutes. Compound A (0.40 g, 0.95 mmol) is then added as a solid and the reaction mixture stirred at 23 °C for 2 hours. A saturated solution of tin (II) chloride in 10% aqueous hydrochloric acid (20 $cm^3$) is added and the reaction mixture stirred at 30 °C for 30 minutes. The mixture cooled, poured into methanol (100 $cm^3$) and the solid collected by filtration. The crude is purified by heated column chromatography (40-60 petrol:dichloromethane; 3:2) followed by recrystallisation (tetrahydrofuran) to give compound B (150 mg, 27%) as a yellow solid. $^1$H-NMR (300 MHz, $CDCl_3$) 0.58 (18H, s), 7.52 - 7.61 (4H, m), 8.00 - 8.07 (2H, m), 8.27 - 8.34 (2H, m), 8.40 (2H, d, J 9.2), 8.84 (2H, d, J 9.2).

Example 2 - Compound C

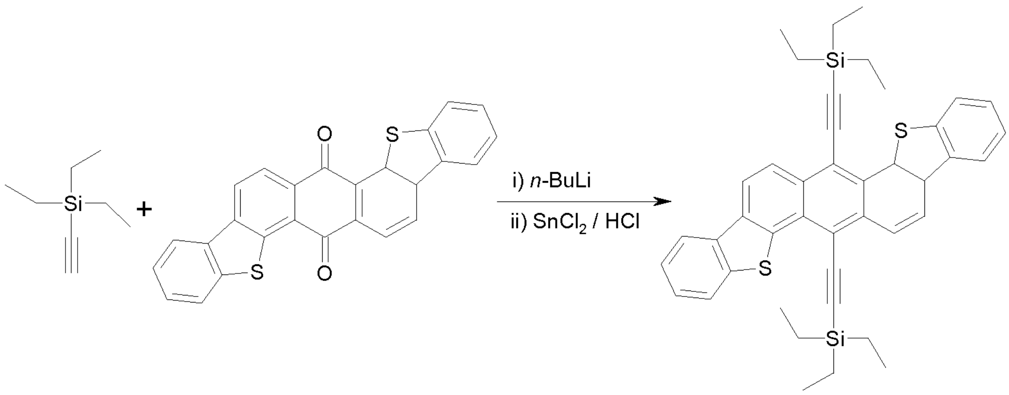


To a solution of (triethylsilyl)acetylene (0.30 g, 2.1 mmol) in anhydrous tetrahydrofuran (10 $cm^3$) at 0 °C is added dropwise n-butyllithium (0.8 $cm^3$, 2 mmol, 2.5 M). After addition, the mixture is stirred at 0 °C for 5 minutes and then at 23 °C for 30 minutes. Compound A (0.09 g, 0.2 mmol) is then added as a solid and the reaction mixture stirred at 23 °C for 3 hours. A saturated solution of tin (II) chloride in 10% aqueous hydrochloric acid (8 $cm^3$) is added and the reaction mixture stirred at 30 °C for 30 minutes. The mixture cooled, poured into methanol (100 $cm^3$) and the solid collected by filtration. The solid is taken up in dichloromethane (100 $cm^3$), washed with water (100 $cm^3$) and the organic dried over anhydrous magnesium sulphate, filtered and the solvent removed *in vacuo*. The crude is purified by column chromatography (gradient from 40-60 petrol to dichloromethane) followed by recrystallisation (tetrahydrofuran/methanol) to give compound C (29 mg, 20%) as an orange/yellow solid. $^1$H-NMR (300 MHz, $CDCl_3$) 0.98 - 1.08 (12H, m), 1.25 - 1.33 (18H, m), 7.52 - 7.61 (4H, m), 7.98 - 8.05 (2H, m), 8.27 - 8.34 (2H, m), 8.39 (2H, d, J 9.1), 8.88 (2H, d, J 9.1).

Example 3 - Compound D

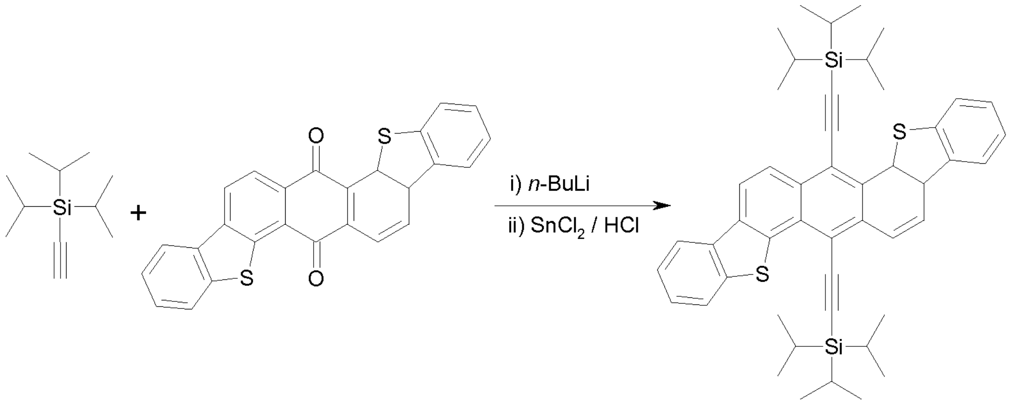


To a solution of (triisopropylsilyl)acetylene (2.1 $cm^3$, 9.5 mmol) in anhydrous tetrahydrofuran (40 $cm^3$) at 0 °C is added dropwise n-butyllithium (3.4 $cm^3$, 8.6 mmol, 2.5 M). After addition, the mixture is stirred at 0 °C for 5 minutes and then at 23 °C for 30 minutes. Compound A (0.40 g, 0.95 mmol) is then added as a solid and the reaction mixture stirred at 23 °C for 41 hours. A saturated solution of tin (II) chloride in 10% aqueous hydrochloric acid (20 $cm^3$) is added and the reaction mixture stirred at 30 °C for 30 minutes. The mixture cooled and poured into water (100 $cm^3$), the solid collected by filtration and washed with methanol (100 $cm^3$). The crude is purified by recrystallisation (tetrahydrofuran/methanol) followed by heated column chromatography (40-60 petrol:dichloromethane; 3:2) followed by recrystallisation (tetrahydrofuran) to give compound D (100 mg, 14%) as an orange solid. $^1H$-NMR (300 MHz, $CDCl_3$) 0.35 - 1.53 (42H, m), 7.51 - 7.60 (4H, m), 7.96 - 8.02 (2H, m), 8.28 - 8.33 (2H, m), 8.37 (2H, d, J 9.1), 8.95 (2H, d, J 9.1).

Example 4 - Compound E

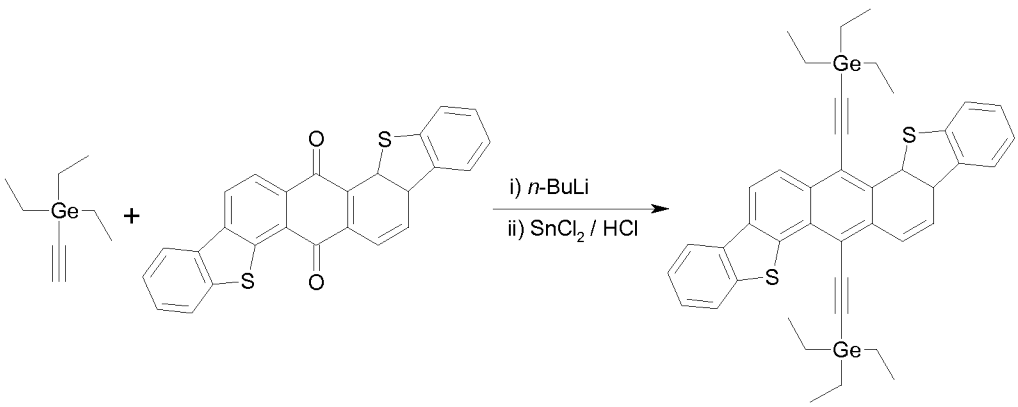


To a solution of (triethylgermyl)acetylene (1.05 g, 5.7 mmol) in anhydrous hexane (10 $cm^3$) is added dropwise n-butyllithium (1.9 $cm^3$, 4.7 mmol, 2.5 M). After addition, the mixture is stirred at 23 °C for 60 minutes. Compound A (0.40 g, 0.95 mmol) is then added as a solid followed by anhydrous hexane (50 $cm^3$) and anhydrous tetrahydrofuran (10 $cm^3$). The reaction mixture is then stirred at 23 °C for 17 hours. Tetrahydrofuran (50 $cm^3$), tin (II) chloride (1.3 g, 6.7 mmol) and 10% aqueous hydrochloric acid (100 $cm^3$) are then added and the mixture stirred for 30 minutes. The volatiles are removed *in vacuo* and the solid collected by filtration The crude is purified by column chromatography (gradient from 40-60 petrol to 20% dichloromethane in 40-60 petrol) to give compound E (20 mg, 3%) as a yellow solid. $^1H$-NMR (300 MHz, $CDCl_3$) 1.22 - 1.42 (30H, m), 7.51 - 7.61 (4H, m), 7.97 - 8.03 (2H, m), 8.27 - 8.32 (2H, m), 8.37 (2H, d, J 9.1), 8.91 (2H, d, J 9.1).

Example 5 - Compound F

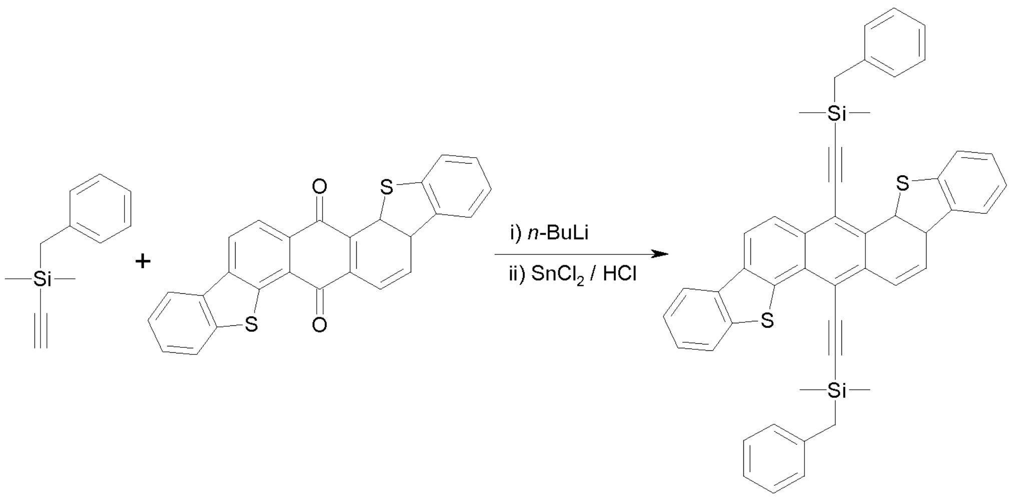


To a solution of (ethynyldimethylsilyl)methyl-benzene (1.0 g, 5.7 mmol) in anhydrous tetrahydrofuran (40 $cm^3$) at 23 °C is added dropwise n-butyllithium (1.9 $cm^3$, 4.8 mmol, 2.5 M). After addition, the mixture is stirred at 23 °C for 60 minutes. Compound A (0.40 g, 0.95 mmol) is then added as a solid and the reaction mixture stirred at 23 °C for 17 hours. A saturated solution of tin (II) chloride in 10% aqueous hydrochloric acid (20 $cm^3$) is added and the reaction mixture stirred at 30 °C for 30 minutes. The mixture cooled and poured into methanol (100 $cm^3$) and the solid collected by filtration. The crude is purified by column chromatography (gradient from 40-60 petrol to 50% dichloromethane in 40-60 petrol) followed by recrystallisation (tetrahydrofuran/methanol) to give compound F (310 mg, 44%) as an orange/yellow solid. $^1$H-NMR (300 MHz, $CDCl_3$) 0.55 (12H, s), 2.60 (4H, s), 7.13 - 7.22 (2H, m), 7.28 - 7.33 (8H, m), 7.55 - 7.61 (4H, m), 7.98 - 8.02 (2H, m), 8.29 - 8.35 (2H, m), 8.35 (2H, d, J 9.0), 8.72 (2H, d, J 9.0).

Use Examples

Transistor Fabrication and Measurement

Top-gate thin-film organic field-effect transistors (OFETs) were fabricated on glass substrates with photolithographically defined Au or Ag source-drain electrodes. A 7 mg/$cm^3$ solution of the organic semiconductor in dichlorobenzene or a 1:1 composition of the organic semiconductor with binder (poly(triarylamine) or polystyrene) in dichlorobenzene at 7 mg/$cm^3$ was drop cast or spin-coated on top (an optional annealing of the film is carried out at 100 °C, 150 °C or 200 °C for between 1 and 5 minutes) followed by a spin-coated fluoropolymer dielectric material (Lisicon® D139 from Merck, Germany). Finally a photolithographically defined Au or Ag gate electrode was deposited. The electrical characterization of the transistor devices was carried out in ambient air atmosphere using computer controlled Agilent 4155C Semiconductor Parameter Analyser. Charge carrier mobility in the saturation regime ($\mu_{sat}$) was calculated for the compound. Field-effect mobility was calculated in the saturation regime ($V_d$ > ($V_g$-$V_0$)) using equation (1):

$$\left(\frac{dI_d^{sat}}{dV_g}\right)_{V_d} = \frac{WC_i}{L}\mu^{sat}(V_g - V_0) \qquad (1)$$

where W is the channel width, L the channel length, $C_i$ the capacitance of insulating layer, $V_g$ the gate voltage, Vo the turn-on voltage, and $\mu_{sat}$ is the charge carrier mobility in the saturation regime. Turn-on voltage (Vo) was determined as the onset of source-drain current.

The mobilities ($\mu_{sat}$) for compounds B, C, D and E in top-gate OFETs are summarised in Table 1.

Table 1: Mobilities ($\mu_{sat}$) for compounds B, C, D and E in top-gate OFETs

| Compound | $\mu_{sat}$ ($cm^2$/Vs) |
|---|---|
| B | 0.09 |
| C | 0.31 |
| D | 0.03 |

(continued)

| Compound | $\mu_{sat}$ ($cm^2/Vs$) |
|---|---|
| E | 0.52 |

## Claims

1. A compound of formula I1

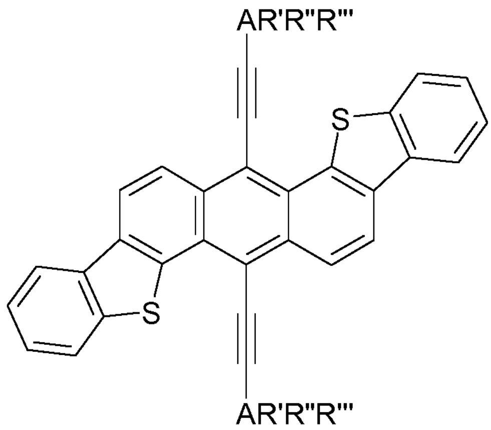

I1

wherein

A denotes C, Si or Ge,
R', R", R''' independently of each other denote H, straight-chain, branched or cyclic alkyl or alkoxy having 1 to 20 C atoms, straight-chain, branched or cyclic alkenyl having 2 to 20 C atoms, straight-chain, branched or cyclic alkynyl having 2 to 20 C atoms, straight-chain, branched or cyclic alkylcarbonyl having 2 to 20 C atoms, aryl or heteroaryl having 4 to 20 ring atoms, arylalkyl or heteroarylalkyl having 4 to 20 ring atoms, aryloxy or heteroaryloxy having 4 to 20 ring atoms, or arylalkyloxy or heteroarylalkyloxy having 4 to 20 ring atoms, wherein all the aforementioned groups are optionally substituted with one or more groups $R^S$,
$R^S$ denotes, on each occurrence identically or differently, F, Br, Cl, -CN, -NC, -NCO, -NCS, -OCN, -SCN,-C(O)$NR^0R^{00}$, -C(O)$X^0$, -C(O)$R^0$, -C(O)O$R^0$, -$NH_2$,-$NR^0R^{00}$, -SH, -$SR^0$, -$SO_3H$, -$SO_2R^0$, -OH, -$NO_2$, -$CF_3$,-$SF_5$, optionally substituted silyl, carbyl or hydrocarbyl with 1 to 40 C atoms that is optionally substituted and optionally comprises one or more hetero atoms,
$X^0$ denotes halogen, preferably F, Cl or Br,
$R^0$ and $R^{00}$ independently of each other denote H or alkyl with 1 to 20 C-atoms,
$Y^0$ and $Y^{00}$ independently of each other denote H, F, Cl or CN.

2. The compound of claim 1, wherein A is Si.

3. The compound of claim 1 or 2, wherein in the groups AR'R"R''' all substituents R', R" and R''' are identical.

4. The compound according to one or more of claims 1 to 3, wherein R', R" and R''' are, independently of each other, selected from optionally substituted and straight-chain, branched or cyclic alkyl or alkoxy having 1 to 10 C atoms, optionally substituted and straight-chain, branched or cyclic alkenyl, alkynyl or alkylcarbonyl having 2 to 12 C atoms, and optionally substituted aryl, heteroaryl, arylalkyl or heteroarylalkyl, aryloxy or heteroaryloxy having 5 to 10 ring atoms.

5. A composition comprising one or more compounds according to one or more of claims 1 to 4, and one or more organic binders or precursors thereof, preferably selected from polymeric organic binders, preferably having a permittivity ε at 1,000 Hz of 3.3 or less.

6. A formulation comprising one or more compounds according to one or more of claims 1 to 4 or a composition

according to claim 5, and further comprising one or more organic solvents.

7. Use of a compound, composition or formulation according according to one or more of claims 1 to 6 as semiconducting, charge transport, electrically conducting, photoconducting, photoactive or light emitting material, or as a dye or pigment, preferably in an optical, electrooptical, electronic, electroluminescent or photoluminescent device, or in a component of such a device or in an assembly comprising such a device or component.

8. A semiconducting, charge transport, electrically conducting, photoconducting, photoactive or light emitting material, or a dye or pigment, comprising one or more compounds according to one or more of claims 1 to 4 or a composition or formulation according to claim 5 or 6.

9. An optical, electrooptical, electronic, photoactive, electroluminescent or photoluminescent device, or a component thereof, or an assembly comprising it, which comprises one or more compounds according to one or more of claims 1 to 4, a composition or formulation according to claim 5 or 6, or a material according to claim 8.

10. The device, component or assembly according to claim 9, which is selected from organic field effect transistors (OFET), organic thin film transistors (OTFT), organic light emitting diodes (OLED), organic light emitting transistors (OLET), organic photovoltaic devices (OPV), organic photodetectors (OPD), organic solar cells, dye-sensitized solar cells (DSSC), laser diodes, Schottky diodes, photoconductors, photodetectors, thermoelectric devices, charge injection layers, charge transport layers, interlayers, planarising layers, antistatic films, polymer electrolyte membranes (PEM), conducting substrates, conducting patterns, integrated circuits (IC), radio frequency identification (RFID) tags or security markings or security devices containing them, flat panel displays or backlights thereof, electrophotographic devices, electrophotographic recording devices, organic memory devices, sensor devices, biosensors and biochips.

## Patentansprüche

1. Verbindung der Formel I1

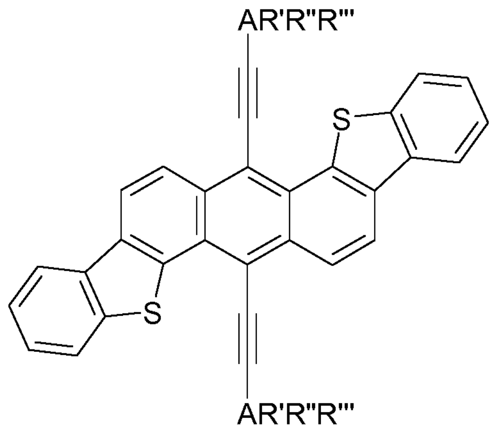

I1

bei der

A C, Si oder Ge bedeutet,

R', R", R''' unabhängig voneinander H, geradkettiges, verzweigtes oder cyclisches Alkyl oder Alkoxy mit 1 bis 20 C-Atomen, geradkettiges, verzweigtes oder cyclisches Alkenyl mit 2 bis 20 C-Atomen, geradkettiges, verzweigtes oder cyclisches Alkinyl mit 2 bis 20 C-Atomen, geradkettiges, verzweigtes oder cyclisches Alkylcarbonyl mit 2 bis 20 C-Atomen, Aryl oder Heteroaryl mit 4 bis 20 Ringatomen, Arylalkyl oder Heteroarylalkyl mit 4 bis 20 Ringatomen, Aryloxy oder Heteroaryloxy mit 4 bis 20 Ringatomen oder Arylalkyloxy oder Heteroarylalkyloxy mit 4 bis 20 Ringatomen bedeuten, bei denen alle vorgenannten Gruppen gegebenenfalls mit einer oder mehreren Gruppen $R^S$ substituiert sind,

$R^S$ bei jedem Auftreten gleich oder verschieden F, Br, Cl, -CN, -NC, -NCO, -NCS, -OCN, -SCN, $-C(O)NR^0R^{00}$, $-C(O)X^0$, $-C(O)R^0$, $-C(O)OR^0$, $-NH_2$, $-NR^0R^{00}$, -SH, $-SR^0$, $-SO_3H$, $-SO_2R^0$, -OH, $-NO_2$, $-CF_3$, $-SF_5$, gegebenenfalls substituiertes Silyl, Carbyl oder Hydrocarbyl mit 1 bis 40 C-Atomen, das gegebenenfalls substituiert ist und

gegebenenfalls ein oder mehrere Heteroatome enthält, bedeutet,
$X^0$ Halogen, vorzugsweise F, Cl oder Br bedeutet,
$R^0$ und $R^{00}$ unabhängig voneinander H oder Alkyl mit 1 bis 20 C-Atomen bedeuten,
$Y^0$ und $Y^{00}$ unabhängig voneinander H, F, Cl oder CN bedeuten.

**2.** Verbindung des Anspruchs 1, bei der A Si ist.

**3.** Verbindung des Anspruchs 1 oder 2, bei der in den Gruppen AR'R"R"' alle Substituenten R', R" und R'" gleich sind.

**4.** Verbindung nach einem oder mehreren der Ansprüche 1 bis 3, bei der R', R" and R'" unabhängig voneinander aus gegebenenfalls substituiertem und geradkettigem, verzweigten oder cyclischem Alkyl oder Alkoxy mit 1 bis 10 C-Atomen, gegebenenfalls substituiertem und geradkettigem, verzweigten oder cyclischem Alkenyl, Alkinyl oder Alkylcarbonyl mit 2 bis 12 C-Atomen und gegebenenfalls substituiertem Aryl, Heteroaryl, Arylalkyl oder Heteroarylalkyl, Aryloxy oder Heteroaryloxy mit 5 bis 10 Ringatomen ausgewählt sind.

**5.** Zusammensetzung enthaltend eine oder mehrere Verbindungen nach einem oder mehreren der Ansprüche 1 bis 4 und ein oder mehrere organische Bindemittel oder Vorläufer davon, vorzugsweise ausgewählt aus polymeren organischen Bindemitteln, vorzugsweise mit einer absoluten Dielektrizitätskonstante $\varepsilon$ bei 1.000 Hz von 3,3 oder weniger.

**6.** Formulierung enthaltend eine oder mehrere Verbindungen nach einem oder mehreren der Ansprüche 1 bis 4 oder eine Zusammensetzung nach Anspruch 5, und ferner enthaltend ein oder mehrere organische Lösungsmittel.

**7.** Verwendung einer Verbindung, Zusammensetzung oder Formulierung nach einem oder mehreren der Ansprüche 1 bis 6 als Halbleiter-, Ladungstransport-, elektrisch leitendes, photoleitendes, photoaktives oder lichtemittierendes Material oder als Farbstoff oder Pigment, vorzugsweise in einer optischen, elektrooptischen, elektronischen, Elektrolumineszenz- oder Photolumineszenzvorrichtung oder in einer Komponente einer solchen Vorrichtung oder in einer Baugruppe, die eine solche Vorrichtung oder Komponente enthält.

**8.** Halbleiter-, Ladungstransport-, elektrisch leitendes, photoleitendes, photoaktives oder lichtemittierendes Material oder Farbstoff oder Pigment, enthaltend eine oder mehrere Verbindungen nach einem oder mehreren der Ansprüche 1 bis 4 oder eine Zusammensetzung oder Formulierung nach Anspruch 5 oder 6.

**9.** Optische, elektrooptische, elektronische, photoaktive, Elektrolumineszenz- oder Photolumineszenzvorrichtung oder Komponente davon oder diese enthaltende Baugruppe, die eine oder mehrere Verbindungen nach einem oder mehreren der Ansprüche 1 bis 4, eine Zusammensetzung oder Formulierung nach Anspruch 5 oder 6 oder ein Material nach Anspruch 8 enthält.

**10.** Vorrichtung, Komponente oder Baugruppe nach Anspruch 9, die aus organischen Feldeffekttransistoren (OFET), organischen Dünnschichttransistoren (OTFT), organischen Leuchtdioden (OLED), organischen lichtemittierenden Transistoren (OLET), organischen Photovoltaikvorrichtungen (OPV), organischen Photodetektoren (OPD), organischen Solarzellen, farbstoffsensibilisierten Solarzellen (DSSC), Laserdioden, Schottky-Dioden, Photoleitern, Photodetektoren, thermoelektrischen Vorrichtungen, Ladungsinjektionsschichten, Ladungstransportschichten, Zwischenschichten, Planarisierungsschichten, Antistatikfolien, Polymerelektrolytmembranen (PEM), leitenden Substraten, leitenden Strukturen, integrierten Schaltungen (IC), RFID(radio frequency identification)-Tags oder diese enthaltenden Sicherheitsmarkierungen oder Sicherheitsvorrichtungen, Flachbildschirmen oder Hintergrundbeleuchtungen davon, elektrophotographischen Vorrichtungen, elektrophotographischen Aufzeichnungsvorrichtungen, organischen Speichervorrichtungen, Sensorvorrichtungen, Biosensoren und Biochips ausgewählt ist.

## Revendications

**1.** Composé de la formule I1 :

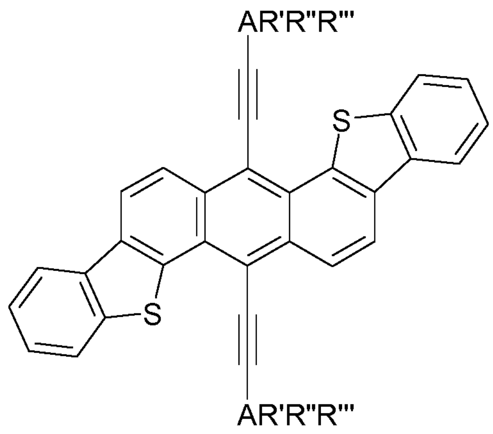

I1

dans laquelle :

A représente C, Si ou Ge ;
R', R", R''' représentent, de manière indépendante les uns des autres, H, alkyle ou alcoxy en chaîne droite, ramifié ou cyclique qui comporte de 1 à 20 atome(s) de C, alkényle en chaîne droite, ramifié ou cyclique qui comporte de 2 à 20 atomes de C, alkynyle en chaîne droite, ramifié ou cyclique qui comporte de 2 à 20 atomes de C, alkylcarbonyle en chaîne droite, ramifié ou cyclique qui comporte de 2 à 20 atomes C, aryle ou hétéroaryle qui comporte de 4 à 20 atomes de cycle, arylalkyle ou hétéroarylalkyle qui comporte de 4 à 20 atomes de cycle, aryloxy ou hétéroaryloxy qui comporte de 4 à 20 atomes de cycle ou arylalkyloxy ou hétéroarylalkyloxy qui comporte de 4 à 20 atomes de cycle, dans lequel tous les groupes qui ont été mentionnés ci-avant sont en option substitués par un ou plusieurs groupe(s) $R^S$ ;
$R^S$ représente, pour chaque occurrence de manière identique ou différente, F, Br, Cl, -CN, -NC, -NCO, -NCS, -OCN, -SCN, $-C(O)NR^0R^{00}$, $-C(O)X^0$, $-C(O)R^0$, $-C(O)OR^0$, $-NH_2$, $-NR^0R^{00}$, -SH, $-SR^0$, $-SO_3H$, $-SO_2R^0$, -OH, $-NO_2$, $-CF_3$, $-SF_5$, silyle, carbyle ou hydrocarbyle en option substitué qui comporte de 1 à 40 atome(s) de C et qui est en option substitué et qui comprend en option un ou plusieurs hétéroatome(s) ;
$X^0$ représente halogène, de préférence F, Cl ou Br ;
$R^0$ et $R^{00}$ représentent, de manière indépendante l'un de l'autre, H ou alkyle qui comporte de 1 à 20 atome(s) de C ;
$Y^0$ et $Y^{00}$ représentent, de manière indépendante l'un de l'autre, H, F, Cl ou CN.

2. Composé selon la revendication 1, dans lequel A est Si.

3. Composé selon la revendication 1 ou 2, dans lequel, dans les groupes AR'R"R''', tous les substituants R', R" et R''' sont identiques.

4. Composé selon une ou plusieurs des revendications 1 à 3, dans lequel R', R" et R''' sont, de manière indépendante les uns des autres, sélectionnés parmi alkyle ou alkcoxy en chaîne droite, ramifié ou cyclique en option substitué qui comporte de 1 à 10 atome(s) de C, alkényle, alkynyle ou alkylcarbonyle en chaîne droite, ramifié ou cyclique en option substitué qui comporte de 2 à 12 atomes de C, et aryle, hétéroaryle, arylalkyle ou hétéroarylalkyle, aryloxy ou hétéroaryloxy en option substitué qui comporte de 5 à 10 atomes de cycle.

5. Composition comprenant un ou plusieurs composé(s) selon une ou plusieurs des revendications 1 à 4, et un ou plusieurs agent(s) de liaison organique(s) ou son/leurs précurseur(s), de préférence sélectionné(s) parmi les agents de liaison organiques polymériques, de préférence ceux qui présentent une permittivité $\varepsilon$ à 1000 Hz de 3,3 ou moins.

6. Formulation comprenant un ou plusieurs composé(s) selon une ou plusieurs des revendications 1 à 4 ou une composition selon la revendication 5, et comprenant en outre un ou plusieurs solvant(s) organique(s).

7. Utilisation d'un composé, d'une composition ou d'une formulation selon une ou plusieurs des revendications 1 à 6 en tant que matériau de semiconduction, de transport de charges, de conduction électrique, de photoconduction, photoactif ou d'émission de lumière, ou en tant que colorant ou que pigment, de préférence dans un dispositif optique, électrooptique, électronique, électroluminescent ou photoluminescent, ou dans un composant d'un tel dispositif ou dans un assemblage qui comprend un tel dispositif ou un tel composant.

**8.** Matériau de semiconduction, de transport de charges, de conduction électrique, de photoconduction, photoactif ou d'émission de lumière, ou un colorant ou un pigment, comprenant un ou plusieurs composé(s) selon une ou plusieurs des revendications 1 à 4 ou une composition ou une formulation selon la revendication 5 ou 6.

**9.** Dispositif optique, électrooptique, électronique, photoactif, électroluminescent ou photoluminescent, ou un composant d'un tel dispositif, ou un assemblage qui comprend un tel dispositif, lequel comprend un ou plusieurs composé(s) selon une ou plusieurs des revendications 1 à 4, une composition ou une formulation selon la revendication 5 ou 6 ou un matériau selon la revendication 8.

**10.** Dispositif, composant ou assemblage selon la revendication 9, lequel est sélectionné parmi les transistors à effet de champ organiques (OFET), les transistors à film mince organiques (OTFT), les diodes à émission de lumière organiques (OLED), les transistors à émission de lumière organiques (OLET), les dispositifs photovoltaïques organiques (OPV), les photodétecteurs organiques (OPD), les cellules solaires organiques, les cellules solaires sensibilisées par colorant(s) (DSSC), les diodes laser, les diodes Schottky, les photoconducteurs, les photodétecteurs, les dispositifs thermoélectriques, les couches d'injection de charges, les couches de transport de charges, les intercouches, les couches de planarisation, les films antistatiques, les membranes électrolytiques polymère (PEM), les substrats de conduction, les motifs de conduction, les circuits intégrés (IC), les étiquettes d'identification radiofréquence (RFID) ou les marquages de sécurité ou les dispositifs de sécurité qui les contiennent, les affichages à écran plat ou leurs éclairages arrière ou rétroéclairages, les dispositifs électrophotographiques, les dispositifs d'enregistrement électrophotographique, les dispositifs de mémoire organiques, les dispositifs de capteur, les biocapteurs et les biopuces.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012076092 A1
- US 20070102696 A1
- US 6630566 B
- US 20040248338 A1
- US 5892244 A
- US 5998804 A
- US 6723394 B
- US 7095044 B
- EP 0889350 A1
- EP 0528662 A
- US 5198153 A
- WO 9621659 A
- US 20030021913 A


### Non-patent literature cited in the description


- **J. E. ANTHONY.** *Angew. Chem. Int. Ed.,* 2008, vol. 47, 452
- **S. F. NELSON ; Y. Y. LIN ; D. J. GUNDLACH ; T. N. JACKSON.** *Appl. Phys. Lett,* 1998, vol. 72, 1854
- **MALIAKAL ; K. RAGHAVACHARI ; H. KATZ ; E. CHANDROSS ; T. SIEGRIST.** *Chem. Mater.,* 2004, vol. 16, 4980
- **DAN LEHNHERR et al.** *Organic Letters,* 2012, vol. 14 (1), 62-65
- *Pure Appl. Chem.,* 1996, vol. 68, 2291
- International Union of Pure and Applied Chemistry. Compendium of Chemical Technology. Gold Book, 19 August 2012, 477, , 480
- **J. THEWLIS.** Concise Dictionary of Physics. Pergamon Press, 1973
- *Pure Appl. Chem.,* 1994, vol. 66, 1134
- **J. M. G. COWIE.** Polymers: Chemistry & Physics of Modern Materials. Blackie, 1991
- **C.M. HANSEN.** *Ind. Eng. and Chem., Prod. Res. and Devl.,* 1970, vol. 9 (3), 282
- Handbook of Solubility Parameters and Other Cohesion Parameters. CRC Press, 1991
- **CROWLEY, J.D. ; TEAGUE, G.S. JR ; LOWE, J.W. JR.** *Journal of Paint Technology,* 1966, vol. 38 (496), 296
- **SOLVENTS, W.H.ELLIS.** *Federation of Societies for Coatings Technology,* 1986, 9-10
- **G. YU ; J. GAO ; J.C. HUMMELEN ; F. WUDL ; A.J. HEEGER.** *Science,* 1995, vol. 270, 1789 ff
- **COAKLEY, K. M. ; MCGEHEE, M. D.** *Chem. Mater.,* 2004, vol. 16, 4533
- **WALDAUF et al.** *Appl. Phys. Lett.,* 2006, vol. 89, 233517
- **MÜLLER.** *Synth. Metals,* 2000, vol. 111-112, 31
- **ALCALA.** *J. Appl. Phys.,* 2000, vol. 88, 7124
- **C. WEDER et al.** *Science,* 1998, vol. 279, 835
- **KOLLER et al.** *Nat. Photonics,* 2008, vol. 2, 684
- **L. CHEN ; D. W. MCBRANCH ; H. WANG ; R. HELGESON ; F. WUDL ; D. G. WHITTEN.** *Proc. Natl. Acad. Sci. U.S.A.,* 1999, vol. 96, 12287
- **D. WANG ; X. GONG ; P. S. HEEGER ; F. RININSLAND ; G. C. BAZAN ; A. J. HEEGER.** *Proc. Natl. Acad. Sci. U.S.A.,* 2002, vol. 99, 49
- **N. DICESARE ; M. R. PINOT ; K. S. SCHANZE ; J. R. LAKOWICZ.** *Langmuir,* 2002, vol. 18, 7785
- **D. T. MCQUADE ; A. E. PULLEN ; T. M. SWAGER.** *Chem. Rev.,* 2000, vol. 100, 2537